(19) Europäisches Patentamt
European Patent Office
Office européen des brevets

(11) Veröffentlichungsnummer : **0 517 657 B1**

# (12) EUROPÄISCHE PATENTSCHRIFT

(45) Veröffentlichungstag der Patentschrift : **27.12.95 Patentblatt 95/52**

(51) Int. Cl.$^6$ : **G03F 7/032,** G03C 9/08, C08G 63/58, C08G 63/52

(21) Anmeldenummer : **92810400.9**

(22) Anmeldetag : **26.05.92**

## (54) Photoempfindliche Zusammensetzungen

(30) Priorität : **04.06.91 CH 1667/91**

(43) Veröffentlichungstag der Anmeldung : **09.12.92 Patentblatt 92/50**

(45) Bekanntmachung des Hinweises auf die Patenterteilung : **27.12.95 Patentblatt 95/52**

(84) Benannte Vertragsstaaten : **AT BE CH DE ES FR GB IT LI NL SE**

(56) Entgegenhaltungen :
**EP-A- 0 171 069**
**DE-A- 2 057 884**
**DE-B- 1 265 414**
**US-A- 3 878 076**

(73) Patentinhaber : **CIBA-GEIGY AG**
**Klybeckstrasse 141**
**CH-4002 Basel (CH)**

(72) Erfinder : **Steinmann, Bettina, Dr.**
**Les Russilles**
**CH-1724 Praroman (CH)**
Erfinder : **Schulthess, Adrian, Dr.**
**Uf em Bärg 22**
**CH-1734 Tentlingen (CH)**
Erfinder : **Hunziker, Max, Dr.**
**Chasseralstrasse 8**
**CH-3186 Düdingen (CH)**

**EP 0 517 657 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die vorliegende Erfindung betrifft photoempfindliche Zusammensetzungen, neue Polyester, ein Verfahren zum Polymerisieren dieser Zusammensetzungen mittels aktinischer Bestrahlung, ein Verfahren zur Herstellung von dreidimensionalen Gegenständen aus den photoempfindlichen Zusammensetzungen sowie die Verwendung dieser Zusammensetzungen zur Herstellung von photopolymerisierten Schichten, insbesondere von drei-dimensionalen Gegenständen, die aus mehreren photopolymerisierten Schichten aufgebaut sind.

Bekanntlich können strahlungsempfindliche, flüssige Harze oder Harzgemische vielseitig angewendet werden, beispielsweise als Beschichtungsmittel, Klebstoffe oder Photoresists. Im Prinzip sollten flüssige Harze oder Harzsysteme generell auch für die Herstellung von dreidimensionalen Gegenständen (3D-Objekten) nach dem im US-Patent 4,575,330 beschriebenen stereolithographischen Verfahren geeignet sein, doch erweisen sich manche Harze als zu viskos, andere wiederum sind zu wenig lichtempfindlich oder unterliegen beim Härten einem zu grossen Schrumpfungsprozess. Auch lassen die Festigkeitseigenschaften der Formkörper bzw. Gegenstände aus photogehärteten Harzen oft zu wünschen übrig.

Mittels des stereolithographischen Verfahrens kann man bekanntlich komplizierte drei-dimensionale Gegenstände aus flüssigen, lichtempfindlichen Harzen herstellen. Solche Gegenstände werden schichtweise aufgebaut, wobei jede neue härtbare Harzschicht durch Vorhärtung mittels UV/VIS-Licht mit der vorhergehenden, vorgehärteten Schicht fest verbunden wird. Der Gesamtaufbau des dreidimensionalen Gegenstandes lässt sich bekanntlich nach einem computergesteuerten Prozess bewerkstelligen.

In den letzten Jahren hat es nicht an Anstrengungen gefehlt, Harzsysteme zu entwickeln, welche für das stereolithographische Verfahren einsetzbar sind. H. Kodama offenbart in Rev. Sci. Instrum. 52 (11) 1170- 1173 (1981) unter dem Handelsnamen "Tevista" ein flüssiges, photohärtbares Harzgemisch bestehend aus einem ungesättigten Polyester, einem Acrylsäureester, Styrol, einem Polymerisationsinitiator und einem Sensibilisator.

Dieses Harzsystem ist für das stereolithographische Verfahren mit dem Nachteil behaftet, dass die Photoempfindlichkeit ungenügend ist und die sogenannte Grünfestigkeit (green strength) der mit Laserstrahlen vorgehärteten Gegenstände relativ niedrig ist.

Im US-Patent 4,575,330 wird ein stereolithographisches Verfahren vorgeschlagen, wonach als flüssiges Harz ein modifiziertes Acrylat eingesetzt wird, das in der Beschreibung als "Potting Compound 363" bezeichnet wird. Solche Harzgemische werden im US-Patent 4,100,141 offenbart. Auch sie haben den Nachteil, dass sie ungenügend photoempfindlich sind und lange Zeiten für die Herstellung von dreidimensionalen Gegenständen nach dem stereolithographischen Verfahren benötigen.

Ausserdem ist dem Fachmann bekannt, dass die bekannten Polyester-, Polyether- oder Polyurethan-(meth-)acrylate im allgemeinen eine (Meth-)Acrylatfunktionalität von etwa 2 haben.

Daher ist es verständlich, dass an die Harze, die in stereolithographischen Verfahren eingesetzt werden sollen, hohe Anforderungen gestellt werden. Beispielsweise soll die Photoempfindlichkeit des Harzsystems so beschaffen sein, dass das Verhältnis von aufgewendeter Strahlungsenergie und erzielter Eindringtiefe in das flüssige photoempfindliche Harzgemisch, wobei die betreffenden Teile sich verfestigen, im vertretbaren Rahmen liegt. Das heisst, bei einem für das stereolithographische Verfahren geeigneten Harz oder Harzgemisch soll mit wenig Strahlungsenergie eine möglichst hohe Härtungstiefe bei gleichzeitig hohem Polymerisationsgrad und guter Grünfestigkeit erreicht werden.

Beim Verfahren der aufeinanderfolgenden Polymerisation von dünnen Schichten, wie es im stereolithographischen Verfahren angewendet wird, ist gewöhnlich keine dieser Schichten völlig ausgehärtet. Der nicht völlig gehärtete Gegenstand wird als Grünling bezeichnet, und den Elastizitätsmodul und die Bruchfestigkeit dieses Grünlings bezeichnet man auch als Grünfestigkeit. Normalerweise wird der Grünling dann mit UV/VIS-Licht gehärtet, beispielsweise mittels einer Quecksilber- oder Xenonbogenlampe. Die Grünfestigkeit eines Werkstückes stellt daher einen wichtigen Parameter dar, da Gegenstände mit einer geringen Grünfestigkeit sich unter ihrem eigenen Gewicht deformieren können, oder sie können sich bei der Aushärtung durchbiegen oder sacken zusammen.

Es wurde nun gefunden, dass aus mehreren voneinander verschiedenen Di- und Tri-(meth-)acrylaten bestehende Zusammensetzungen, die ausserdem einen Polyester enthalten, bei dem das Molekulargewicht und die (Meth-)Acrylatfunktionalität in weiten Grenzen variierbar sind, für stereolithographische Verfahren eingesetzt werden können. Durch die Bestrahlung können somit unterschiedlich hohe Vernetzungdichte erreicht werden, was zur Folge hat, dass sich sowohl die bei der Vorhärtung mittels Laserstrahlen entstehenden Grünlinge als auch die durch Aushärtung der Grünlinge erhaltenen Gegenstände durch in weiten Grenzen variierbare Eigenschaften auszeichnen.

Gegenstand vorliegender Erfindung ist somit eine photoempfindliche Zusammensetzung enthaltend

a) mindestens 5 Gew.-% eines Polyesters der Formeln I, II oder III

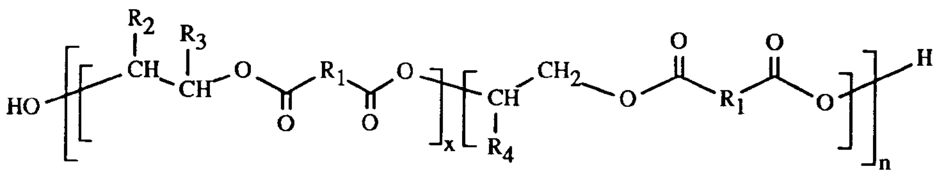
, (I)

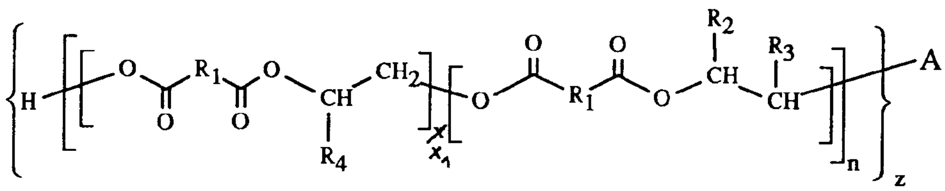
, (II)

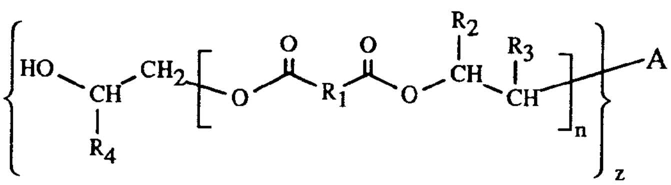
, (III)

worin

$R_1$ den Rest eines cyclisches Anhydrids einer Dicarbonsäure nach dem Entfernen der -CO-O-CO--Gruppierung darstellt, das durch $C_1$-$C_{22}$-Alkyl, $C_5$-$C_{10}$-Cycloalkyl, $C_3$-$C_6$-Alkenyl, $C_6$-$C_{10}$-Aryl, Halogen oder $C_1$-$C_{22}$-Alkyl, das durch -O- oder -CO-O-unterbrochen ist, substituiert sein kann,

$R_2$ Wasserstoff, unsubstituiertes oder durch Halogen substituiertes $C_1$-$C_{22}$-Alkyl, $C_5$-$C_{10}$-Cycloalkyl, $C_7$-$C_{12}$-Aralkyl, $C_6$-$C_{10}$-Aryl oder einen Rest $-CH_2-O-R_5$ oder $-CH_2-O-CO-R_5$ bedeutet, wobei $R_5$ $C_1$-$C_{22}$-Alkyl, $C_5$-$C_6$-Cycloalkyl oder $C_6$-$C_{10}$-Aryl bedeutet,

$R_3$ Wasserstoff ist oder

$R_2$ und $R_3$ zusammen mit den Kohlenstoffatomen, an die sie gebunden sind, einen Cyclopentylen- oder Cyclohexylenrest darstellen,

$R_4$ ein Rest mit 4 bis 12 Kohlenstoffatomen, der eine ungesättigte Endgruppe und Carboxyl- oder Ethergruppen enthält,

A ein ein- bis mehrfunktionelles niedermolekulares oder hochmolekulares Carboxylat oder Alkoholat darstellt,

x eine Zahl von 0-100 ist,

$x_1$ eine Zahl von 1 - 100 ist,

n eine Zahl von 2-150 ist und

z eine Zahl von 1-4 ist,

b) 10-90 Gew.-% eines flüssigen, aliphatischen, cycloaliphatischen oder aromatischen Di(meth-)acrylates und eines flüssigen, aliphatischen, cycloaliphatischen oder aromatischen Tri(meth-)acrylates,

c) 0-70 Gew.-% eines Mono-(meth-)acrylates oder einer Mono-N-vinylverbindung mit einem Molekulargewicht von höchstens 500,

d) 0,1-10 Gew.-% eines Photoinitiators und gegebenenfalls

e) 0-10 Gew.-% übliche Additive,

wobei die Gesamtsumme aller eingesetzten Komponenten immer 100 Gew.-% beträgt.

Bedeutet ein Substituent $C_1$-$C_{22}$-Alkyl, so kann dieses gradkettig oder verzweigt sein. Beispielsweise handelt es sich um Methyl, Ethyl, n-Propyl, Isopropyl, n-Butyl, sec-Butyl, Isobutyl, Pentyl, Hexyl, Heptyl, Octyl, Nonyl, Decyl, Undecyl, Dodecyl, Tetradecyl, Hexadecyl, Icosyl oder Docosyl.

Bedeutet ein Substituent $C_5$-$C_{10}$-Cycloalkyl, so handelt es sich beispielsweise um Cyclopentyl, Cyclohexyl, Cycloheptyl, Cyclooctyl, Cyclononyl oder Cyclodecyl.

Bedeutet ein Substituent $C_3$-$C_6$-Alkenyl, so handelt es sich beispielsweise um 1-Methylethenyl, 1-Propenyl, 2-Propenyl (Allyl), sowie die verschiedenen Butenyl-, Pentenyl- oder Hexenyl-Isomere.

Bedeutet ein Substituent $C_6$-$C_{10}$-Aryl, so handelt es sich beispielsweise um Phenyl oder Naphthyl.

Bedeutet ein Substituent Halogen, so handelt es sich um Fluor, Chlor, Brom oder Jod.

Bedeutet ein Substituent $C_7$-$C_{12}$-Aralkyl, so handelt es sich um Benzyl, 2-Phenylethyl, 3-Phenylpropyl oder

4-Phenylbutyl.

Vorzugsweise enthält die photoempfindliche Zusammensetzung

a) mindestens 30 Gew.-% eines Polyester der Formeln I, II oder III,

b) mindestens 20 Gew.-% eines flüssigen, aliphatischen, cycloaliphatischen oder aromatischen Di(meth-)acrylats und eines flüssigen, aliphatischen, cycloaliphatischen oder aromatischen Tri(meth-)acrylats,

c) 0-50 Gew.-% eines Mono-(meth-)acrylates oder einer Mono-N-vinylverbindung mit einem Molekulargewicht von höchstens 500,

d) 0,5-7 Gew.-% eines Photoinitiators und gegebenenfalls

e) 0-5 Gew.-% übliche Additive.

Die in den erfindungsgemässen Zusammensetzungen als Komponente a) verwendeten Polyester können in an sich bekannter Weise hergestellt werden. Beispielsweise können Polyester der Formel I durch Copolymerisation der entsprechenden cyclischen Anhydride mit Monoepoxiden erhalten werden, wobei mindestens eines dieser Epoxide eine strahlenhärtbare, ungesättigte Gruppe enthalten muss. Als Initiatoren für diese Polymerisation können tertiäre Amine, Metallalkoxide oder Salze von Brønsted-Sänren verwendet werden. Polyester der Formel II können zum Beispiel durch Copolymerisation der entsprechenden cyclischen Anhydride und Monoepoxiden zusammen mit Salzen von ein- bis mehrfunktionellen Säuren oder Alkoholen erhalten werden, wobei mindestens eines dieser Epoxide eine strahlenhärtbare, ungesättigte Gruppe enthalten muss. Polyester der Formel III können zum Beispiel durch Polymerisation der entsprechenden cyclischen Anhydride und gesättigten Monoepoxiden zusammen mit Salzen von ein- bis mehrfunktionellen Säuren oder Alkoholen erhalten werden, die anschliessend im gleichen Schritt noch mit einem ungesättigten Monoepoxid umgesetzt werden. Es wurde gefunden, dass lösliche Polyester erhalten werden, wenn Nitrobenzol oder Nitromethan als Inhibitoren zugesetzt werden, die eine Gelierung (durch Polymerisation der Doppelbindungen) verhindern.

Viele der Polyesterkomponeten a) stellen bekannte Verbindungen dar und sind zum Beispiel in den JP-Kokai 49-086490 und 62-005853 offenbart. Einige der Verbindungen dagegen sind noch neu. Gegenstand der vorliegenden Erfindung sind somit Polyester der oben aufgeführten Formeln II und III, wobei die Reste $R_1$, $R_2$, $R_3$, $R_4$, $R_5$ und A, sowie x, $x_1$, n und z die oben angegebene Bedeutung haben.

Bevorzugt sind photoempfindliche Zusammensetzungen, worin $R_1$ einen Rest der Formeln

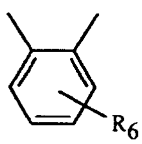 , 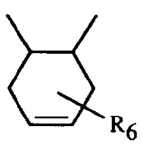 , 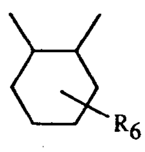 , 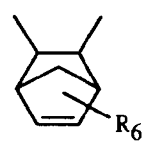 ,

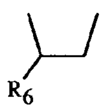 , 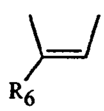 , 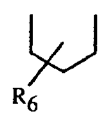 oder 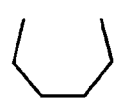 ,

darstellt, wobei $R_5$ Wasserstoff, $C_1$-$C_{22}$-Alkyl, $C_5$-$C_{10}$-Cycloalkyl, $C_3$-$C_6$-Alkenyl, $C_6$-$C_{10}$-Aryl, Halogen oder $C_1$-$C_{22}$-Alkyl, das durch -O- oder -CO-O- unterbrochen ist, bedeutet.

Besonders bevorzugt sind photoempfindliche Zusammensetzungen, worin $R_1$ einen Rest der Formeln

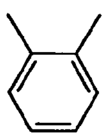 , 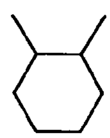 oder 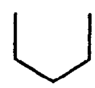

darstellt.

Weiterhin bevorzugt sind photoempfindliche Zusammensetzungen, worin $R_2$ Wasserstoff, Methyl, n-Butyl, $H_3C$-$(CH_2)_3$-O-$CH_2$- oder ein Rest der Formeln

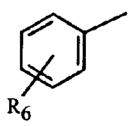, 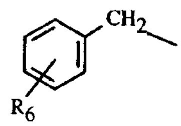, 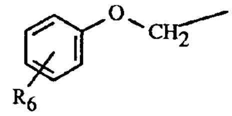 oder 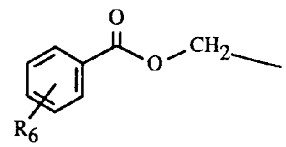

bedeutet, oder worin $R_2$ und $R_3$ zusammen einen unsubstituierten oder mit $R_6$ substituierten Tetramethylenrest bilden, wobei $R_6$ die oben angegebene Bedeutung hat.

Insbesondere bevorzugt sind photoempfindliche Zusammensetzungen, worin $R_2$ n-Butyl, $H_3C-(CH_2)_3-O-CH_2-$ oder ein Rest der Formeln

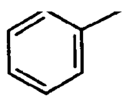, 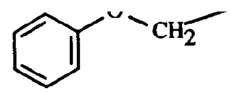 oder 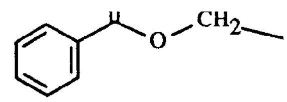

bedeutet.

$R_4$ enthält mindestens eine Carboxyl- oder Ethergruppe. Bevorzugt sind photoempfindliche Zusammensetzungen, worin $R_4$ einen Rest der Formeln

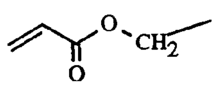, 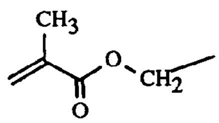 oder 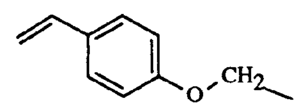

darstellt.

Bevorzugt sind ebenfalls photoempfindliche Zusammensetzungen, worin A ein Rest $H_3C-(CH_2)_y-CO-O-$, $H_3C-(CH_2)_y-O-$, $-O-CO-(CH_2)_y-CO-O-$, $-O-(CH_2)_y-O-$ oder

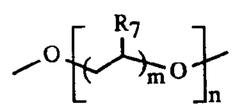

bedeutet, wobei R7 Methyl oder Wasserstoff bei m = 1 oder bei m = 2-4 Wasserstoff ist, n = 2-150 ist und y eine Zahl von 2-20 ist, oder worin A einen Rest basierend auf linearen oder verzweigten Polyethylenglykolen oder Polypropylenglykolen oder Copolymeren aus diesen beiden Glykolen oder carboxylterminierten Polyestern darstellt.

Insbesondere bevorzugt sind photoempfindliche Zusammensetzungen, worin A ein Rest $-O-CO-(CH_2)_y-CO-O-$ oder $-O-(CH_2)_y-O-$ bedeutet, wobei y die oben angegebene Bedeutung hat, oder worin A einen Rest basierend auf linearen oder verzweigten Polyethylenglykolen oder Polypropylenglykolen oder Copolymeren aus diesen beiden Glykolen oder carboxylterminierten Polyestern darstellt.

Die in den erfindungsgemässen Zusammensetzungen als Komponente b) verwendeten flüssigen, aliphatischen, cycloaliphatischen oder aromatischen (Meth-)Acrylate sind di- und trifunktionelle monomere oder oligomere Acrylat- oder Methacrylatester.

Als aliphatische oder cycloaliphatische Di(meth-)acrylate eignen sich beispielsweise die Diacrylat- und Dimethacrylatester von aliphatischen oder cycloaliphatischen Diolen, wie 1,3-Butandiol, 1,4-Butandiol, Neopentylglykol, 1,6-Hexandiol, Diethylenglykol, Triethylenglykol, Tetraethylenglykol, Polyethylenglykol-400, Polyethylenglykol-600, Tripropylenglykol, ethoxyliertes oder propoxyliertes Neopentylglykol, 1,4-Dihydroxymethylcyclohexan, 2,2-Bis-(4-hydroxycyclohexyl)-propan oder Bis-(4-hydroxycyclohexyl)-methan.

Als aliphatische trifunktionelle (Meth-)Acrylate eignen sich beispielsweise die Triacrylat- und Trimethacrylatester von Hexan-2,4,6-triol, Glycerin oder 1,1,1-Trimethylolpropan, ethoxyliertes oder propoxyliertes Glycerin oder 1,1,1 -Trimethylolpropan und die hydroxygruppenhaltigen Tri(meth)acrylate, die durch Umsetzung von Triepoxidverbindungen, wie beispielsweise die Triglycidylether von den genannten Triolen, mit (Meth-)Acrylsäure erhalten werden.

Als aromatische Di- und Tri(meth-)acrylate eignen sich beispielsweise die Umsetzungsprodukte aus Di- oder Triglycidylethern zwei- oder dreiwertiger Phenole, wie Resorcin, Hydrochinon, Bis-(4-hydroxyphenyl)-methan, 4,4′-Dihydroxydiphenyl, Bis-(4-hydroxyphenyl)-sulfon, 1,1,2,2-Tetrakis-(4-hydroxyphenyl)-ethan, 2,2-Bis-(4-hydroxyphenyl)-propan, ethoxyliertes oder propoxyliertes 2,2-Bis-(4-hydroxyphenyl)-propan und 2,2-Bis-(3,5-dibrom-4-hydroxyphenyl)-propan und drei Hydroxylgruppen aufweisende Phenol- oder Kresolnovolake mit (Meth)-Acrylsäure.

Ausserdem können Urethanacrylate oder Urethanmethacrylate verwendet werden. Diese Urethan(meth-)acrylate sind dem Fachmann bekannt und können in bekannter Weise hergestellt werden, indem man beispielsweise ein hydroxylterminiertes Polyurethan mit Acrylsäure oder Methacrylsäure zu dem entsprechenden Urethan(meth-)acryalat umsetzt, oder indem man ein isocyanatterminiertes Präpolymer mit Hydroxyalkylacrylaten oder -methacrylaten zum Urethan(meth-)acryalat umsetzt. Entsprechende Verfahren werden zum Beispiel in EP-A 114 982 und 133 908 offenbart. Das Molekulargewicht solcher (Meth-)acrylate liegt im allgemeinen in Bereich von 400 bis 10000, vorzugsweise zwischen 500 bis 7000.

Die als Komponente b) eingesetzten (Meth-)Acrylate stellen bekannte Verbindungen dar und sind zum Teil im Handel erhältlich, beispielsweise von der Firma SARTOMER Company.

In den erfindungsgemässen Zusammensetzungen können als Komponente c) beispielsweise folgende Verbindungen enthalten sein:
Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecylacrylat und -methacrylat, 2-Hydroxyethylacrylat oder -methacrylat, 2- und 3-Hydroxypropylacrylat und -methacrylat, 2-Methoxyethyl-, 2-Ethoxyethyl- und 2- oder 3-Ethoxypropylacrylat, Tetrahydrofurfurylmethacrylat, 2-(2-Ethoxyethoxy)ethylacrylat, Cyclohexylmethacrylat, 2-Phenoxyethylacrylat oder -methacrylat, Glycidylacrylat oder -methacrylat und Isodecylacrylat sowie als Mono-N-vinylverbindung N-Vinylpyrrolidon oder N-Vinylcaprolactam. Solche Produkte sind ebenfalls bekannt und zum Teil im Handel erhältlich, zum Beispiel von der Firma SARTOMER Company.

Vorzugsweise weisen die Verbindungen der Komponente c) ein Molekulargewicht von 50-300 auf.

Die erfindungsgemässen Zusammensetzungen enthalten als Komponente c) vorzugsweise eine Mono-N-vinylverbindung, insbesondere N-Vinylpyrrolidon.

In den erfindungsgemässen Zusammensetzungen können alle Typen von Photoinitiatoren als Komponente d) eingesetzt werden, welche bei der entsprechenden Bestrahlung freie Radikale bilden. Typische Verbindungen bekannter Photoinitiatoren sind Benzoine, wie Benzoin, Benzoinether, wie Benzoinmethylether, Benzoinethylether und Benzoinisopropylether, Benzoinphenylether und Benzoinacetat, Acetophenone, wie Acetophenon, 2,2-Dimethoxyacetophenon und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert.-Butylanthrachinon, 1-Chloranthrachinon und 2-Amylanthrachinon, ferner Triphenylphosphin, Benzoylphosphinoxide, wie beispielsweise 2,4,6-Trimethylbenzoyldiphenylphosphinoxid (Luzirin®) TPO), Benzophenone, wie Benzophenon und 4,4′-Bis-(N,N′-dimethylamino)-benzophenon,Thioxanthone und Xanthone, Acridinderivate Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton, welche alle bekannte Verbindungen darstellen.

Besonders geeignete Photoinitiatoren, welche gewöhnlich in Kombination mit einem He/Cd-Laser als Lichtquelle verwendet werden, sind Acetophenone, wie 2,2-Dialkoxybenzophenone und 1-Hydroxyphenylketone, beispielsweise 1-Hydroxycyclohexylphenylketon oder 2-Hydroxyisopropylphenylketon (= 2-Hydroxy-2,2-dimethylacetophenon), insbesondere aber 1-Hydroxycyclohexylphenylketon.

Eine andere Klasse von Photoinitiatoren d), die gewöhnlich bei Verwendung von Argonion-Lasern eingesetzt wird, sind die Benzilketale, wie beispielsweise Benzildimethyketal. Insbesondere verwendet man als Photoinitiator ein $\alpha$-Hydroxyphenylketon, Benzildimethylketal oder 2,4,6-Trimethylbenzoyldiphenylphosphinoxid.

Eine weitere Klasse von geeigneten Photoinitiatoren d) stellen die ionischen Farbstoff-Gegenionverbindungen (ionic dye-counter ion compound) dar, welche in der Lage sind, aktinische Strahlen zu absorbieren und freie Radikale zu erzeugen, die die Polymerisation der Acrylate initiieren können. Die erfindungsgemässen Zusammensetzungen, welche ionische Farbstoff-Gegenionverbindungen enthalten, können auf diese Weise variabler mit sichtbarem Licht im einstellbaren Wellenlängenbereich von 400-700 nm gehärtet werden. Ionische Farbstoff-Gegenionverbindungen und deren Wirkungsweise sind bekannt, beispielsweise aus EP 223 587 und den US-Patenten 4,751,102; 4,772,530 und 4,772,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der folgenden Formel

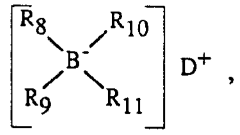

worin $D^+$ für einen kationischen Farbstoff steht und $R_8$, $R_9$, $R_{10}$ und $R_{11}$ unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten. Bevorzugte Definitionen für die Reste $R_8$ bis $R_{11}$ können beispielsweise aus EP 223 587 entnommen werden.

Die Photoinitiatoren werden bekanntlich in wirksamen Mengen zugesetzt, das heisst, in Mengen von etwa 0,1 bis etwa 10 Gewichtsprozent, bezogen auf die Gesamtmenge der Zusammensetzung. Wenn die erfindungsgemässen Zusammensetzungen für stereolithographische Verfahren verwendet werden, wobei normalerweise Laserstrahlen eingesetzt werden, ist es wesentlich, dass die Absorptionsfähigkeit der Zusammensetzung durch Typ und Konzentration des Photoinitiators so abgestimmt wird, dass die Härtungstiefe bei normaler Lasergeschwindigkeit ungefähr 0,1 bis 2,5 mm beträgt.

Die erfindungsgemässen Zusammensetzungen können auch verschiedene Photoinitiatoren enthalten, welche gegenüber Strahlen von Emissionslinien unterschiedlicher Wellenlängen verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Vorzugsweise enthalten die erfindungsgemässen Zusammensetzungen als Photoinitiator d) ein 1-Hydroxyphenylketon, insbesondere 1-Hydroxycyclohexylphenylketon.

Falls erwünscht können den erfindungsgemässen Zusammensetzungen die üblichen Additive e) zugesetzt werden, beispielsweise Stabilisatoren, wie UV-Stabilisatoren, Polymerisationsinhibitoren, Trennmittel, Benetzungsmittel, Verlaufsmittel, Sensibilisatoren, Anti-absetzmittel, oberflächenaktive Mittel, Farbstoffe, Pigmente oder Füllstoffe.

Die erfindungsgemässen Zusammensetzungen können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, zweckmässig in Abwesenheit von Licht und gegebenenfalls bei leicht erhöhter Temperatur.

Die erfindungsgemässen, photoempfindlichen Zusammensetzungen können durch Bestrahlen mit aktinischem Licht, beispielsweise mittels Elektronen-, Röntgenstrahlen, UV-oder VIS-Licht, das heisst, mit elektromagnetischer Strahlung oder Teilchenstrahlung im Wellenlängenbereich von 280-650 nm, polymerisiert werden. Besonders geeignet sind Laserstrahlen von He/Cd, Argon- oder Stickstoff- sowie Metalldampf- und NdYAG-Laser mit vervielfachter Frequenz. Es ist dem Fachmann bekannt, dass für jede gewählte Lichtquelle der geeignete Photoinitiator ausgewählt und gegebenenfalls sensibilisiert werden muss. Man hat erkannt, dass die Eindringtiefe der Strahlung in die zu polymerisierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche die höchste Anzahl von entstehenden freien Radikalen bewirken und die grösste Strahlungseindringtiefe in die zu polymerisierenden Zusammensetzungen ermöglichen.

Gegenstand der Erfindung ist somit auch ein Verfahren zum Polymerisieren der erfindungsgemässen Zusammensetzungen, indem man diese mit aktinischem Licht bestrahlt. Die erhaltenen Polymerisate können beispielsweise als Beschichtungsmittel, Photoresists oder Klebstoffe verwendet werden.

Es war nicht voraussehbar, dass die Polyesterkomponente a) der erfindungsgemässen Zusammensetzungen mit den üblichen (Meth-)Acrylaten, die für die Formulierung von strahlenhärtbaren Gemischen verwendet werden, sehr gut verträglich sind. Ausserdem lösen sich auch die in fester Form anfallenden Polyester gut in den entsprechenden (Meth-)Acrylatgemischen. Ebenfalls weisen die erfindungsgemässen Zusammensetzungen überraschenderweise eine hohe Photoempfindlichkeit auf.

Ein weiterer Erfindungsgegenstand ist auch ein Verfahren zur Herstellung von dreidimensionalen Gegenständen aus einer erfindungsgemässen Zusammensetzung mittels lithographischen Verfahren, insbesondere stereolithographischen Verfahren, wobei die Oberfläche einer Schicht aus der erfindungsgemässen Zusammensetzung ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht aus der erfindungsgemässen Zusammensetzung auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als Lichtquelle vorzugsweise ein Laserstrahl verwendet, der in einer besonders bevorzugten Ausführungsform computergesteuert ist.

Werden die erfindungsgemässen Zusammensetzungen als Beschichtungsmittel eingesetzt, so erhält man klare und harte Beschichtungen auf Holz, Papier, Metall, Keramik oder anderen Oberflächen. Die Beschichtungsdicke kann dabei sehr variieren und etwa von 1 µm bis etwa 1 mm betragen. Aus den erfindungsgemässen Gemischen können Reliefbilder für gedruckte Schaltungen oder Druckplatten direkt durch Bestrahlen der Gemische hergestellt werden, beispielsweise mittels eines computergesteuerten Laserstrahls geeigneter Wellenlänge oder unter Anwendung einer Photomaske und einer entsprechenden Lichtquelle.

Eine weitere Verwendungsmöglichkeit ist der Einsatz der erfindungsgemässen Zusammensetzungen als photohärtbare Klebstoffe.

Vorzugsweise verwendet man die erfindungsgemässen Zusammensetzungen zur Herstellung von photopolymerisierten Schichten, insbesondere in Form von dreidimensionalen Gegenständen, die aus mehreren aneinander haftenden, verfestigten Schichten aufgebaut sind.

Die folgenden Beispiele illustrieren die vorliegende Erfindung weiter.

## I. Herstellung der Polyester (Komponente a)

### Polyester I:

2,5 g Glycidylmethacrylat (0,0176 mol) werden unter $N_2$ in einen getrockneten Rundkolben eingefüllt. Anschliessend werden ebenfalls unter $N_2$ 2,64 g (0,0178 mol) Phthalsäureanhydrid und 28,8 mg (0,35 mmol) 1-Methylimidazol hinzugegeben. Nach Hinzufügen von 0,1 g Nitrobenzol und 10 ml trockenem, destillierten Toluol wird bei 80 °C bis zum vollständigem Umsatz der Epoxidgruppen gerührt. Nach 30-stündiger Reaktionszeit wird das Produkt mit Ether ausgefällt und anschliessend aus Aceton/Ether (1 : 1) umgefällt. Nach dem Trocknen wird ein weisses Pulver erhalten. Ausbeute: 2,7 g (54 % der Theorie);
$M_n$ = 4000, $M_w$ = 8400.

### Polyester II:

Wie in Beispiel I werden die folgenden Komponenten unter $N_2$ in einem getrockneten Rundkolben vermischt:

| | |
|---|---|
| 20,0 g | Phenylglycidylether (0,133 mol) |
| 1,89 g | Glycidylmethacrylat (0,0133 mol) |
| 21,65 g | Phthalsäureanhydrid (0,146 mol) |
| 0,24 g | 1-Methylimidazol (0,0029 mol) |
| 40 ml | Toluol |
| 0,84 g | Nitrobenzol |

Die Lösung wird während 24 Stunden unter $N_2$ bei 80 °C gerührt. Die sehr viskose Lösung wird dann mit 100 ml Methylenchlorid verdünnt und das Produkt mit 500 ml Ether ausgefällt. Es wird eine ölige, gelbe Masse erhalten, die nochmals aus Methylenchlorid/Ether (1 : 1) umgefällt wird. Nach dem Trocknen wird ein weisses Pulver erhalten.
Ausbeute: 21,0 g (48 % der Theorie);
$M_n$ = 11800, $M_w$ = 14400;
$T_g$ = 48-56 °C;
Gehalt an Doppelbindungen: 0,3 Äqu./kg.

### Polyester III:

Wie in Beispiel I werden die folgenden Komponenten unter $N_2$ in einem getrockneten Rundkolben vermischt:

| | |
|---|---|
| 20,0 g | Phenylglycidylether (0,133 mol) |
| 1,70 g | Glycidylacrylat (0,0133 mol) |
| 21,65 g | Phthalsäureanhydrid (0,146 mol) |
| 0,24 g | 1-Methylimidazol (0,0029 mol) |
| 40 ml | Toluol |
| 0,84 g | Nitrobenzol |

Die Lösung wird bei während 24 Stunden unter $N_2$ bei 80 °C gerührt. Das Produkt wird mit Ether ausgefällt und nochmals aus Aceton/Ether (1 : 1) umgefällt. wird. Nach dem Trocknen wird ein weisses Pulver erhalten.
Ausbeute: 32,2 g (77,4 % der Theorie);
$M_n$ = 6500, $M_w$ = 11400;
Gehalt an Doppelbindungen: 0,4 Äqu./kg.

Polyester IV:

Wie in Beispiel I werden die folgenden Komponenten unter $N_2$ in einem getrockneten Rundkolben vermischt:

| | |
|---|---|
| 13,3 g | Butyloxiran (0,133 mol) |
| 8,45 g | Glycidylacrylat (0,066 mol) |
| 23,96 g | Glutarsäureanhydrid (0,21 mol) |
| 0,32 g | 1-Methylimidazol (0,004 mol) |
| 50 ml | Toluol |
| 0,5 g | Nitrobenzol |

Die Lösung wird während 24 Stunden unter $N_2$ bei 80 °C gerührt. Anschliessend wird das Lösungsmittel in Rotationsverdampfer entfernt, der Rückstand mit Ether gewaschen und dann getrocknet. Es wird ein gelbliches, flüssiges Harz erhalten.
Ausbeute: 35 g (75 % der Theorie);
$M_n$ = 1600, $M_w$ = 2100;

Polyester V:

Wie in Beispiel I werden die folgenden Komponenten unter $N_2$ in einem getrockneten Rundkolben vermischt:

| | |
|---|---|
| 30,0 g | Phenylglycidylether (0,2 mol) |
| 12,8 g | Glycidylacrylat (0,1 mol) |
| 48,6 g | Hexahydrophthalsäureanhydrid (0,31 mol) |
| 0,48 g | 1-Methylimidazol (0,006 mol) |
| 60 ml | Toluol |
| 0,92 g | Nitrobenzol |

Die Lösung wird während 24 Stunden unter $N_2$ bei 80 °C gerührt. Das Produkt wird mit Ether ausgefällt und nochmals aus Methylenchlorid/Ether (1 : 1) umgefällt. Nach dem Trocknen wird ein beiges Pulver erhalten.
Ausbeute: 52,3 g (57 % der Theorie);
$M_n$ = 1800, $M_w$ = 2800.

Polyester VI:

Wie in Beispiel I werden die folgenden Komponenten unter $N_2$ in einem getrockneten Rundkolben vermischt:

| | |
|---|---|
| 39,7 g | Butylglycidylether (0,305 mol) |
| 19,53 g | Glycidylacrylat (0,15 mol) |
| 55,0 g | Glutarsäureanhydrid (0,48 mol) |
| 0,73 g | 1-Methylimidazol (0,009 mol) |
| 110 ml | Toluol |
| 1,15 g | Nitrobenzol |

Die Lösung wird während 20 Stunden unter $N_2$ bei 80 °C gerührt. Das Produkt wird dann mit einer 5 %igen wässrigen $NaHCO_3$-Lösung extrahiert und die organische Phase im Vakuum eingeengt. Es wird eine viskose, gelbe Flüssigkeit erhalten.
Ausbeute: 50,3 g (44 % der Theorie);
$M_n$ = 530, $M_w$ = 700.

Polyester VII:

13,02 g Butylglycidylether (0,1 mol) werden mit 13,7 g (0,12 mol) Glutarsäureanhydrid und 0,16 g (0,001 mol) Bernsteinsäure-di-Na-Salz unter $N_2$ vermischt. Die Mischung wird unter $N_2$ auf 120 °C erhitzt und 20 Stunden bei dieser Temperatur gerührt. Das Reaktionsprodukt (eine braune, viskose Flüssigkeit) wird in Methylenchlorid gelöst und mit einer 5 %igen wässrigen $NaHCO_3$-Lösung extrahiert. Die organische Phase wird im Vakuum eingeengt. Es wird eine gelbe Flüssigkeit erhalten.
Ausbeute: 25,3 g (94,7 % der Theorie);
$M_n$ = 760, $M_w$ = 1000;
Gehalt an COOH-Endgruppen: 1,46 Äqu./kg.
9,0 g dieses carboxylterminierten Polyesters (0,013 Äqu. COOH) werden mit 3,66 g (0,0286 mol) Glycidylacrylat, 0,09 g Tetraethylammoniumbromid, 0,032 g p-Methoxyphenol und 25 ml Toluol auf 80 °C erhitzt. Die Lösung wird solange gerührt, bis der Gehalt an Epoxidgruppen konstant bleibt. Das Produkt wird anschliessend aus Hexan ausgefällt.
Ausbeute: 5,3 g (49 % der Theorie);
$M_n$ = 923, $M_w$ = 2300;
Gehalt an Doppelbindungen: 1,68 Äqu./kg.

Polyester VIII:

13,02 g Butylglycidylether (0,1 mol) werden mit 18,48 g (0,12 mol) Hexahydrophthalsäureanhydrid und 0,16 g (0,001 mol) Bernsteinsäure-di-Na-Salz unter $N_2$ vermischt. Die Mischung wird unter $N_2$ auf 140 °C erhitzt und 34 Stunden bei dieser Temperatur gerührt. Die Reaktionsprodukt wird in Methylenchlorid gelöst und mit 300 ml Ether ausgefällt. Nach dem Trocknen wird ein weisses Pulver erhalten.
Ausbeute: 11,6 g (34,6 % der Theorie);
$M_n$ = 4500, $M_w$ = 7200;
Gehalt an COOH-Endgruppen: 0,35 Äqu./kg.
9,0 g dieses carboxylterminierten Polyesters (0,0031 Äqu. COOH) werden mit 0,9 g (0,007 mol) Glycidylacrylat, 0,09 g Tetraethylammoniumbromid, 0,03 g p-Methoxyphenol und 25 ml Toluol auf 90 °C erhitzt. Die Lösung wird solange gerührt, bis der Gehalt an Epoxidgruppen konstant bleibt. Das Produkt wird anschliessend aus Hexan ausgefällt.
Ausbeute: 6,3 g (67 % der Theorie);
$M_n$ = 3000, $M_w$ = 9000;
Gehalt an Doppelbindungen: 0,23 Äqu./kg.

Polyester IX:

13,02 g Butylglycidylether (0,1 mol) werden mit 15,41 g (0,1 mol) Hexahydrophthalsäureanhydrid, 0,16 g (0,001 mol) Bernsteinsäure-di-Na-Salz und 0,3 g Nitrobenzol unter $N_2$ in einem getrockneten Rundkolben vermischt. Die Mischung wird unter $N_2$ auf 80 °C erhitzt und 24 Stunden bei dieser Temperatur gerührt. Anschliessend werden 6,4 g Glycidylacrylat (0,05 mol) hinzugefügt und weitere 24 Stunden gerührt. Das Produkt wird anschliessend mit Hexan ausgefällt und nochmals aus Methylen/Hexan (1 : 1) umgefällt. Es wird ein hellbraunes viskoses Harz erhalten.
$M_n$ = 6500, $M_w$ = 29500;
Gehalt an Doppelbindungen: 0,87 Äqu./kg.

Polyester X:

25 g Polyethylenglykol 2000 (0,025 Äqu. OH) werden in 30 ml trockenem Dioxan gelöst. 4,5 g einer 30 %igen Natrium-Suspension in Toluol werden hinzugefügt und 1 Stunde bei Raumtemperatur gerührt. Diese Mischung wird unter $N_2$ filtiert. Zum Filtrat werden 18,5 g Phthalsäureanhydrid (0,125 mol), 9,38 g Phenylglycidylether (0,0625 mol), 8,0 g Glycidylacrylat (0,0625 mol) und 0,4 g Nitrobenzol hinzugefügt und unter $N_2$ bei 80 °C während 24 Stunden gerührt. Das Produkt wird mit Ether ausgefällt und aus Methylenchlorid/Hexan (1 : 1) umgefällt.
$M_n$ = 2960, $M_w$ = 5070.

Polyester XI:

25 g Desmophen® 1600 U [lineares Polyol der Fa. Bayer AG (0,05 Äqu. OH)] werden in 25 ml trockenem Dioxan gelöst. 4,5 g einer 30 %igen Natrium-Suspension in Toluol werden hinzugefügt und bei Raumtemperatur gerührt, bis eine klare Lösung entsteht. Dann werden 29,62 g Phthalsäureanhydrid (0,2 mol), 15,02 g Phenylglycidylether (0,1 mol), 12,81 g Glycidylacrylat (0,1 mol) und 0,8 g Nitrobenzol hinzugefügt und unter $N_2$ bei 80 °C während 48 Stunden gerührt. Das Produkt wird in Methylenchlorid gelöst und mit Ether ausgefällt.

Ausbeute: 44,5 g (48 % der Theorie);
$M_n$ = 3200, $M_w$ = 12100;
Gehalt an Doppelbindungen: 0,88 Äqu./kg.

Polyester XII:

Das Beispiel XI wird wiederholt, mit der Ausnahme, dass statt Phenylglycidylether 13,02 g Butylglycidylether (0,1 mol) verwendet werden. Das Produkt wird aus Methylenchlorid/Hexan (1 : 1) umgefällt.
Ausbeute: 54,35 g (67,6 % der Theorie);
$M_n$ = 1800, $M_w$ = 2500;
Gehalt an Doppelbindungen: 0,89 Äqu./kg.

Polyester XIII:

25 g Polytetrahydrofuran 1000 (0,05 Äqu. OH) werden in 200 ml trockenem Toluol gelöst. 3,83 g einer 30 %igen Natrium-Suspension in Toluol werden hinzugefügt und 1 Stunde bei Raumtemperatur gerührt, bis eine klare Lösung entsteht. Dann werden 37,02 g Phthalsäureanhydrid (0,25 mol), 18,8 g Phenylglycidylether (0,125 mol), 15,98 g Glycidylacrylat (0,125 mol) und 1 g Nitrobenzol hinzugefügt und unter $N_2$ bei 80 °C während 48 Stunden gerührt. Das Produkt wird mit Hexan ausgefällt.
Ausbeute: 75,3 g (78 % der Theorie);
$M_n$ = 2800, $M_w$ = 3900;

Polyester XIV:

Wie in Beispiel I werden die folgenden Komponenten unter $N_2$ in einem getrockneten Rundkolben vermischt:

| | |
|---|---|
| 20,0 g | Phenylglycidylether (0,133 mol) |
| 9,38 g | Glycidylmethacrylat (0,066 mol) |
| 29,45 g | Phthalsäureanhydrid (0,199 mol) |
| 0,32 g | 1-Methylimidazol (0,004 mol) |
| 50 ml | Toluol |
| 1,14 g | Nitrobenzol |

Die Lösung wird während 24 Stunden unter $N_2$ bei 80 °C gerührt. Die sehr viskose Lösung wird dann mit 100 ml Methylenchlorid verdünnt und das Produkt mit 500 ml Ether ausgefällt. Es wird eine ölige, gelbe Masse erhalten, die nochmals aus Methylenchlorid/Ether (1 : 1) umgefällt wird. Nach dem Trocknen wird ein weisses Pulver erhalten.
Ausbeute: 40,5 g (67,5 % der Theorie);
$M_n$ = 10700, $M_w$ = 14200;
Gehalt an Doppelbindungen: 0,8 Äqu./kg.

Polyester XV:

Wie in Beispiel I werden die folgenden Komponenten unter $N_2$ in einem getrockneten Rundkolben vermischt:

| | |
|---|---|
| 13,3 g | Butyloxiran (0,133 mol) |
| 8,51 g | Glycidylacrylat (0,066 mol) |
| 29,45 g | Hexahydrophthalsäureanhydrid (0,21 mol) |
| 0,32 g | 1-Methylimidazol (0,004 mol) |
| 50 ml | Toluol |
| 0,60 g | Nitrobenzol |

Die Lösung wird während 13 Stunden unter $N_2$ bei 80 °C gerührt. Das Produkt wird anschliessend mit einer 5 %igen wässrigen $NaHCO_3$-Lösung extrahiert und die organische Phase wird in Vakuum eingeengt. Es wird ein gelbiches, viskoses Harz erhalten.
Ausbeute: 50,2 g (90,7 % der Theorie);
$M_n$ = 1330, $M_w$ = 1840.

II. Herstellung von 3D-Objekten

Beispiel 1:

5 g eines Polyesters gemäss Beispiel XIV mit einem Doppelbindungsgehalt von 0,8 Äqu./kg werden mit 5 g N-Vinylpyrrolidon und 0,4 g 1-Hydroxycyclohexylphenylketon (Irgacure® 184 der Fa. Ciba-Geigy) bei 40 °C solange gerührt, bis eine homogene, klare Lösung entsteht. Mit Hilfe eines He/Cd-Lasers werden 3-dimensionale Körper hergestellt. Nach der Laserhärtung (Grünlinge) haben diese Körper folgende Eigenschaften:

| | |
|---|---|
| E-Modul: | 2-3 $N/mm^2$ |
| (Elastizitätsmodul gemäss DIN 53371; green strength); | |
| Bruchfestigkeit $\sigma_{max}$: | 1 $N/mm^2$ |
| (gemäss DIN 53455); | |
| Bruchdehnung $\epsilon$: | 41 % |
| (gemäss DIN 35455); | |

Zur vollständigen Aushärtung werden die Grünlinge 30 Minuten mit UV/VIS-Licht bestrahlt. Die Körper weisen anschliessend folgende Eigenschaften auf:

| | |
|---|---|
| E-Modul: | 231 $N/mm^2$; |
| Bruchfestigkeit $\sigma_{max}$: | 14 $N/mm^2$; |
| Bruchdehnung $\varepsilon$: | 28 %. |

Beispiel 2:

35 g eines Polyesters gemäss Beispiel II mit einem Doppelbindungsgehalt von 0,3 Äqu./kg werden mit 35 g Polyethylenglykol-400-diacrylat (SR 344® der Fa. Sartomer), 25 g Trimethylolpropantriacrylat und 5 g 1-Hydroxycyclohexylphenylketon (Irgacure® 184 der Fa. Ciba-Geigy) bei 40 °C solange gerührt, bis eine homogene, klare Lösung entsteht. Mit Hilfe eines He/Cd-Lasers werden 3-dimensionale Körper hergestellt. Nach der Laserhärtung (Grünlinge) haben diese Körper folgende Eigenschaften:

| | |
|---|---|
| E-Modul: | 17 $N/mm^2$ |
| (Elastizitätsmodul gemäss DIN 53371; green strength); | |
| Bruchfestigkeit $\sigma_{max}$: | 3 $N/mm^2$ |
| (gemäss DIN 53455); | |
| Bruchdehnung $\epsilon$: | 16 % |
| (gemäss DIN 35455); | |

Zur vollständigen Aushärtung werden die Grünlinge 30 Minuten mit UV/VIS-Licht bestrahlt. Die Körper weisen anschliessend folgende Eigenschaften auf:

| | |
|---|---|
| E-Modul: | 665 $N/mm^2$; |
| Bruchfestigkeit $\sigma_{max}$: | 21 $N/mm^2$; |
| Bruchdehnung $\varepsilon$: | 3 %; |
| Shore-D-Härte: | 70. |

Beispiele 3-13:

Es werden wie in Beispiel I Formulierungen aus den in Tabelle 1 angegebenen Komponenten hergestellt und zu dreidimensionalen Formkörpern bzw. zu Platten unter den in den Beispielen 1 und 2 angegebenen Bedingungen verarbeitet. Die Mengenangaben in Tabelle 1 sind Gewichts-%, bezogen auf das Gesamtgewicht der entsprechenden Formulierung. Die Eigenschaften der erhaltenen Formkörper sind in Tabelle 2 angegeben.

Tabelle 1

| Beispiel | 3 | 4 | 5 | 6 | 7 | 8 | 9 | 10 | 11 | 12 | 13 |
|---|---|---|---|---|---|---|---|---|---|---|---|
| Polyester Bsp. III | 35 | 35 | | | | | | | | | |
| Polyester Bsp. VI | | | 35 | | | | | | | | |
| Polyester Bsp. IV | | | | 35 | | | | | | | |
| Polyester Bsp. VIII | | | | | 20 | | | | | | |
| Polyester Bsp. X | | | | | | 35 | | | | | |
| Polyester Bsp. XI | | | | | | | 35 | | | | |
| Polyester Bsp. XII | | | | | | | | 35 | | | |
| Polyester Bsp. XV | | | | | | | | | 20 | | |
| Polyester Bsp. IV | | | | | | | | | | 20 | 40 |
| SR 344 [1)] | 35 | | | | | | | | 14,85 | 20 | 20 |
| SR 351 [1)] | | 25 | 25 | 25 | 50 | 25 | 25 | 25 | | | |
| SR 350 [1)] | 25 | | | | | | | | | | |
| SR 230 [1)] | | 35 | 35 | 35 | 25 | 35 | 35 | 35 | | | |
| SR 339 [1)] | | | | | | | | | | 10 | 10 |
| SR 348 [1)] | | | | | | | | | 20 | 24,85 | 24,85 |
| SR 9640 [1)] | | | | | | | | | 40 | 20 | |
| 4-Methoxyphenol | | | | | | | | | 0,15 | 0,15 | 0,15 |
| Irgacure 184 [1)] | 5 | 5 | 5 | 5 | 5 | 5 | 5 | 5 | 5 | 5 | 5 |

1) SR 344: Polyethylenglykol-400-diacrylat (Sartomer)
SR 350: Trimethylolpropantrimethacrylat (Sartomer)
SR 351: Trimethylolpropantriacrylat (Sartomer)
SR 230: Diethylenglykoldiacrylat (Sartomer)
SR 339: Phenoxyethylacrylat (Sartomer)
SR 348: ethoxyliertes Bisphenol-A-dimethacrylat
SR 9640: aliphatisches Urethanacrylat (Sartomer)
Irgacure 184: 1-Hydroxycyclohexylphenylketon (Ciba-Geigy)

Tabelle 2

| Beispiel | 3 | 4 | 5 | 6 | 7 | 8 | 9 | 10 | 11 | 12 | 13 |
|---|---|---|---|---|---|---|---|---|---|---|---|
| $\eta$ (35°C) (mPa·s) | 1970 | 795 | 43 | 35 | 151 | 1420 | 3760 | 113 | 3810[4)] | 1090[4)] | 1740[4)] |
| E-Modul ($N/mm^2$)[2)] | 1,2 | 66 | 12,4 | 8,5 | 51,9 | 35 | 23,7 | 17 | 2,44 | 1,94 | 1,76 |
| $\sigma_{max}$ ($N/mm^2$)[2)] | 0,1 | 1,9 | 0,6 | 0,6 | 3,2 | 3,7 | 3,2 | 2,0 | 0,43 | 0,25 | 0,46 |
| $\epsilon$ (%)[2)] | 9 | 4,1 | 4,9 | 6,2 | 7,7 | 12 | 13,1 | 11,7 | 15,8 | 13,4 | 23 |
| E-Modul ($N/mm^2$)[3)] | 610 | 1650 | 599 | 648 | 2510 | 2080 | 1980 | 1160 | 26,4 | 334 | 257 |
| $\sigma_{max}$ ($N/mm^2$)[3)] | 21 | 54 | 17 | 15,7 | 26,7 | 42,9 | 46,7 | 24,4 | 7,5 | 18,3 | 11,6 |
| $\epsilon$ (%)[3)] | 10 | 2,9 | 6 | 4,2 | 1,2 | 3,7 | 2,6 | 3,8 | 23,6 | 24,6 | 13,5 |

2) Werte nach Laserhärtung (40 $mJ/cm^2$)
3) Werte nach vollständiger Aushärtung
4) Viskosität bei 30 °C

**Patentansprüche**

**Patentansprüche für folgende Vertragsstaaten : AT, BE, CH, DE, FR, GB, IT, LI, NL, SE**

1. Photoempfindliche Zusammensetzungen enthaltend
   a) mindestens 5 Gew.-% eines Polyesters der Formeln I, II oder III

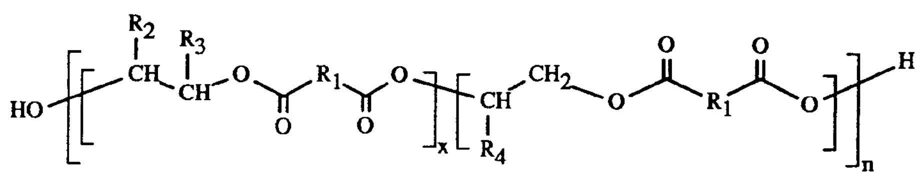
, (I)

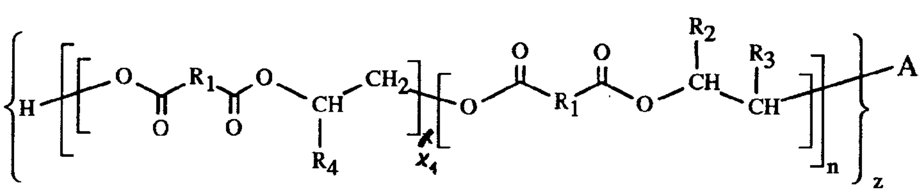
, (II)

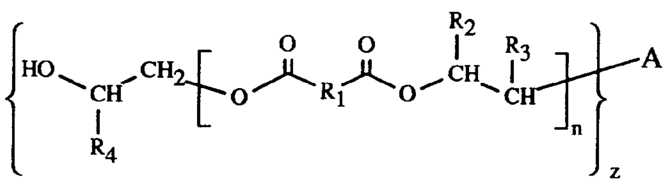
, (III)

worin
$R_1$ den Rest eines cyclisches Anhydrids einer Dicarbonsäure nach dem Entfernen der -CO-O-CO--Gruppierung darstellt, das durch $C_1$-$C_{12}$-Alkyl, $C_5$-$C_{10}$-Cycloalkyl, $C_3$-$C_6$-Alkenyl, $C_6$-$C_{10}$-Aryl, Halogen oder $C_1$-$C_{22}$-Alkyl, das durch -O- oder -CO-O- unterbrochen ist, substituiert sein kann,

$R_2$ Wasserstoff, unsubstituiertes oder durch Halogen substituiertes $C_1$-$C_{22}$-Alkyl, $C_5$-$C_{10}$-Cycloalkyl, $C_7$-$C_{12}$-Aralkyl, $C_6$-$C_{10}$-Aryl oder einen Rest $-CH_2-O-R_5$ oder $-CH_2-O-CO-R_5$ bedeutet, wobei $R_5$ $C_1$-$C_{22}$-Alkyl, $C_5$-$C_6$-Cycloalkyl oder $C_6$-$C_{10}$-Aryl bedeutet,

$R_3$ Wasserstoff ist oder

$R_2$ und $R_3$ zusammen mit den Kohlenstoffatomen, an die sie gebunden sind, einen Cyclopentylen- oder Cyclohexylenrest darstellen,

$R_4$ ein Rest mit 4 bis 12 Kohlenstoffatomen, der eine ungesättigte Endgruppe und Carboxyl- oder Ethergruppen enthält,

A ein ein- bis mehrfunktionelles niedermolekulares oder hochmolekulares Carboxylat oder Alkoholat darstellt,

x eine Zahl von 0-100 ist,

$x_1$ eine Zahl von 1-100 ist,

n eine Zahl von 2-150 ist und

z eine Zahl von 1-4 ist,

b) 10-90 Gew.-% eines flüssigen, aliphatischen, cycloaliphatischen oder aromatischen Di(meth-)acrylates und eines flüssigen, aliphatischen, cycloaliphatischen oder aromatischen Tri(meth-)acrylates,

c) 0-70 Gew.-% eines Mono-(meth-)acrylates oder einer Mono-N-vinylverbindung mit einem Molekulargewicht von höchstens 500,

d) 0,1-10 Gew.-% eines Photoinitiators und gegebenenfalls

e) 0-10 Gew.-% übliche Additive,

wobei die Gesamtsumme aller eingesetzten Komponenten immer 100 Gew.-% beträgt.

2. Photoempfindliche Zusammensetzungen gemäss Anspruch 1 enthaltend

a) mindestens 30 Gew.-% eines Polyester der Formeln I, II oder III,

b) mindestens 20 Gew.-% eines flüssigen, aliphatischen, cycloaliphatischen oder aromatischen Di-(meth-)acrylates und eines flüssigen, aliphatischen, cycloaliphatischen oder aromatischen Tri(meth-)acrylates,

c) 0-50 Gew.-% eines Mono-(meth-)acrylates oder einer Mono-N-vinylverbindung mit einem Molekulargewicht von höchstens 500,

d) 0,5-7 Gew.-% eines Photoinitiators und gegebenenfalls

e) 0-5 Gew.-% übliche Additive.

3. Photoempfindliche Zusammensetzungen gemäss Anspruch 1, worin in den Formeln I, II und III $R_1$ einen Rest der Formeln

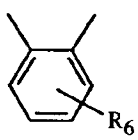 , 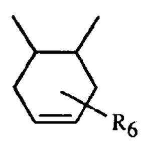 , 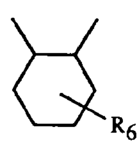 , 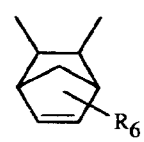 ,

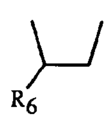 , 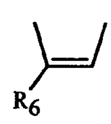 , 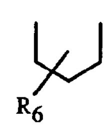 oder 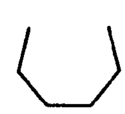 ,

darstellt, wobei $R_6$ Wasserstoff, $C_1$-$C_{22}$-Alkyl, $C_5$-$C_{10}$-Cycloalkyl, $C_3$-$C_6$-Alkenyl, $C_6$-$C_{10}$-Aryl, Halogen oder $C_1$-$C_{22}$-Alkyl, das durch -O- oder -CO-O- unterbrochen ist, bedeutet.

4. Photoempfindliche Zusammensetzungen gemäss Anspruch 3, worin $R_1$ einen Rest der Formeln

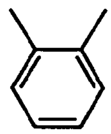 , 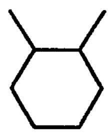 oder 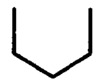

darstellt.

5. Photoempfindliche Zusammensetzungen gemäss Anspruch 1, worin in den Formeln I, II und III $R_2$ Wasserstoff, Methyl, n-Butyl, $H_3C-(CH_2)_3-O-CH_2-$ oder einen Rest der Formeln

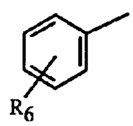 , 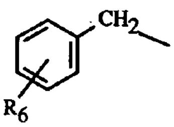 , 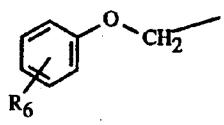 oder 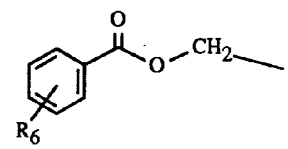

bedeutet, oder worin $R_2$ und $R_3$ zusammen einen unsubstituierten oder mit $R_6$ substituierten Tetramethylenrest bilden, wobei $R_6$ die in Anspruch 3 angegebene Bedeutung hat.

6. Photoempfindliche Zusammensetzungen gemäss Anspruch 5, worin $R_2$ n-Butyl, $H_3C-(CH_2)_3-O-CH_2-$ oder einen Rest der Formeln

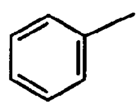 , 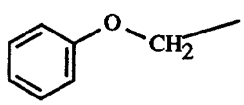 oder 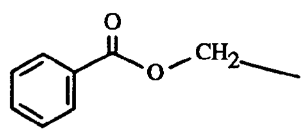

bedeutet.

7. Photoempfindliche Zusammensetzungen gemäss Anspruch 1, worin in den Formeln I, II und III $R_4$ einen Rest der Formeln

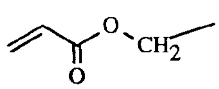 , 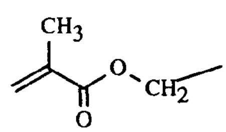 oder 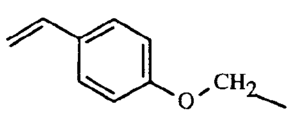

darstellt.

8. Photoempfindliche Zusammensetzungen gemäss Anspruch 1, worin in den Formeln II und III A ein Rest $H_3C-(CH_2)_y-CO-O$, $H_3C-(CH_2)_y-O-$, $-O-CO-(CH_2)_y-CO-O-$, $-O-(CH_2)_y-O-$ oder

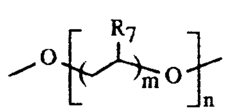

bedeutet, wobei $R_7$ Methyl oder Wasserstoff bei m = 1 oder bei m = 2-4 Wasserstoff ist, n = 2-150 ist und y eine Zahl von 2-20 ist, oder worin A einen Rest basierend auf linearen oder verzweigen Polyethylenglykolen oder Polypropylenglykolen oder Copolymeren aus diesen beiden Glykolen oder carboxylterminierten Polyestern darstellt.

9. Photoempfindliche Zusammensetzungen gemäss Anspruch 8, worin A ein Rest $-O-CO-(CH_2)_y-CO-O-$ oder $-O-(CH_2)_y-O-$ bedeutet, wobei y die in Anspruch 8 angegebene Bedeutung hat, oder worin A einen

Rest basierend auf linearen oder verzweigten Polyethylenglykolen oder Polypropylenglykolen oder Copolymeren aus diesen beiden Glykolen oder carboxylterminierten Polyestern darstellt.

**10.** Polyester der Formeln II und III gemäss Anspruch 1, wobei die Reste $R_1$, $R_2$, $R_3$, $R_4$, $R_5$ und A, sowie x, $x_1$, n und z die in Anspruch 1 angegebene Bedeutung haben.

**11.** Photoempfindliche Zusammensetzungen gemäss Anspruch 1, enthaltend als Komponente c) eine Mono-N-vinylverbindung.

**12.** Photoempfindliche Zusammensetzungen gemäss Anspruch 11, enthaltend als Komponente c) N-Vinylpyrrolidon.

**13.** Photoempfindliche Zusammensetzungen gemäss Anspruch 1, enthaltend als Komponente d) ein 1-Hydroxyphenylketon.

**14.** Photoempfindliche Zusammensetzungen gemäss Anspruch 1, enthaltend als Komponente d) 1 -Hydroxycyclohexylphenylketon.

**15.** Verfahren zum Polymerisieren der Zusammensetzungen gemäss Anspruch 1, indem man diese mit aktinischem Licht bestrahlt.

**16.** Verfahren zur Herstellung von dreidimensionalen Gegenständen aus einer Zusammensetzung gemäss Anspruch 1 mittels lithographischen Verfahren, wobei die Oberfläche einer Schicht der besagten Zusammensetzung ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht dieser Zusammensetzung auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

**17.** Verfahren gemäss Anspruch 16, indem als Lichtquelle ein Laserstrahl, vorzugsweise ein computergesteuerter Laserstrahl, verwendet wird.

**18.** Verwendung einer Zusammensetzung gemäss Anspruch 1 zur Herstellung von photopolymerisierten Schichten, insbesondere in Form von dreidimensionalen Gegenständen, die aus mehreren aneinander haftenden, verfestigten Schichten aufgebaut sind.

**Patentansprüche für folgenden Vertragsstaat : ES**

1. Photoempfindliche Zusammensetzungen enthaltend
   a) mindestens 5 Gew.-% eines Polyesters der Formeln I, II oder III

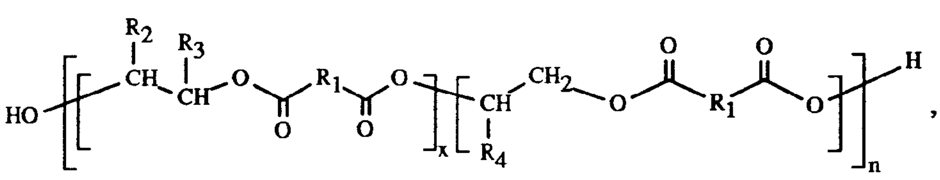 , (I)

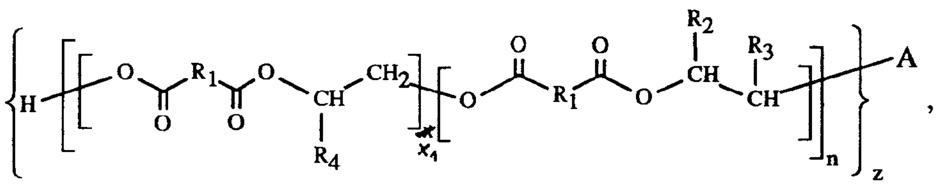 , (II)

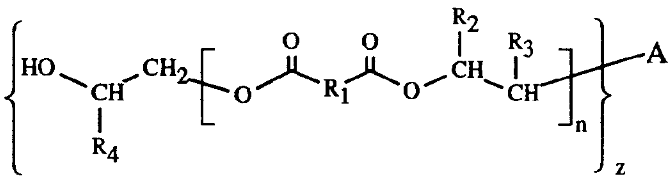 , (III)

worin
$R_1$ den Rest eines cyclisches Anhydrids einer Dicarbonsäure nach dem Entfernen der -CO-O-CO--Gruppierung darstellt, das durch $C_1$-$C_{22}$-Alkyl, $C_5$-$C_{10}$-Cycloalkyl, $C_3$-$C_6$-Alkenyl, $C_6$-$C_{10}$-Aryl, Halogen oder $C_1$-$C_{22}$-Alkyl, das durch -O- oder -CO-O-unterbrochen ist, substituiert sein kann,
$R_2$ Wasserstoff, unsubstituiertes oder durch Halogen substituiertes $C_1$-$C_{22}$-Alkyl, $C_5$-$C_{10}$-Cycloalkyl, $C_7$-$C_{12}$-Aralkyl, $C_6$-$C_{10}$-Aryl oder einen Rest $-CH_2$-O-$R_5$ oder $-CH_2$-O-CO-$R_5$ bedeutet, wobei $R_5$ $C_1$-$C_{22}$-Alkyl, $C_5$-$C_6$-Cycloalkyl oder $C_6$-$C_{10}$-Aryl bedeutet,
$R_3$ Wasserstoff ist oder
$R_2$ und $R_3$ zusammen mit den Kohlenstoffatomen, an die sie gebunden sind, einen Cyclopentylen- oder Cyclohexylenrest darstellen,
$R_4$ ein Rest mit 4 bis 12 Kohlenstoffatomen, der eine ungesättigte Endgruppe und Carboxyl- oder Ethergruppen enthält,
A ein ein- bis mehrfunktionelles niedermolekulares oder hochmolekulares Carboxylat oder Alkoholat darstellt,
x eine Zahl von 0-100 ist,
$x_1$ eine Zahl von 1-100 ist,
n eine Zahl von 2-150 ist und
z eine Zahl von 1-4 ist,
b) 10-90 Gew.-% eines flüssigen, aliphatischen, cycloaliphatischen oder aromatischen Di(meth-)acrylats und eines flüssigen, aliphatischen, cycloaliphatischen oder aromatischen Tri(meth-)acrylats,
c) 0-70 Gew.-% eines Mono-(meth-)acrylates oder Mono-N-vinylverbindung mit einem Molekulargewicht von höchstens 500,
d) 0,1-10 Gew.-% eines Photoinitiators und gegebenenfalls
e) 0-10 Gew.-% übliche Additive,
wobei die Gesamtsumme aller eingesetzten Komponenten immer 100 Gew.-% beträgt.

2. Photoempfindliche Zusammensetzungen gemäss Anspruch 1 enthaltend
a) mindestens 30 Gew.-% eines Polyester der Formeln I, II oder III,
b) mindestens 20 Gew.-% eines flüssigen, aliphatischen, cycloaliphatischen oder aromatischen Di-(meth-)acrylats und eines flüssigen, aliphatischen, cycloaliphatischen oder aromatischen Tri(meth-) acrylats,
c) 0-50 Gew.-% eines Mono-(meth-)acrylates oder Mono-N-vinylverbindung mit einem Molekulargewicht von höchstens 500,
d) 0,5-7 Gew.-% eines Photoinitiators und gegebenenfalls
e) 0-5 Gew.-% übliche Additive.

3. Photoempfindliche Zusammensetzungen gemäss Anspruch 1, worin in den Formeln I, II und III $R_1$ einen Rest der Formeln

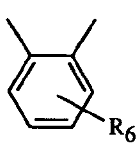 , 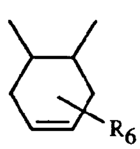 , 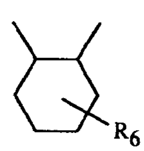 , 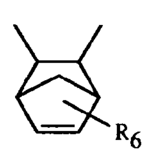 ,

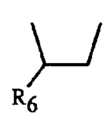 , 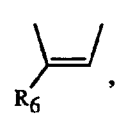 , 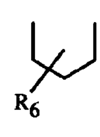 oder 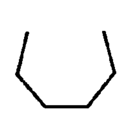 ,

darstellt, wobei $R_6$ Wasserstoff, $C_1$-$C_{22}$-Alkyl, $C_5$-$C_{10}$-Cycloalkyl, $C_3$-$C_6$-Alkenyl, $C_6$-$C_{10}$-Aryl, Halogen

oder $C_1$-$C_{22}$-Alkyl, das durch -O- oder -CO-O- unterbrochen ist, bedeutet.

**4.** Photoempfindliche Zusammensetzungen gemäss Anspruch 3, worin $R_1$ einen Rest der Formeln

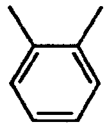 , 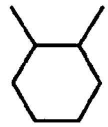 oder 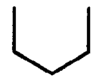

darstellt.

**5.** Photoempfindliche Zusammensetzungen gemäss Anspruch 1, worin in den Formeln I, II und III $R_2$ Wasserstoff, Methyl, n-Butyl, $H_3C$-$(CH_2)_3$-O-$CH_2$- oder einen Rest der Formeln

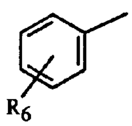 , 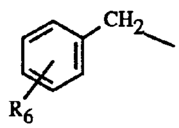 , 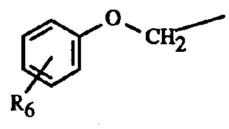 oder 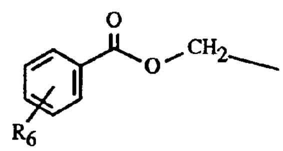

bedeutet, oder worin $R_2$ und $R_3$ zusammen einen unsubstituierten oder mit $R_6$ substituierten Tetramethylenrest bilden, wobei $R_6$ die in Anspruch 3 angegebene Bedeutung hat.

**6.** Photoempfindliche Zusammensetzungen gemäss Anspruch 5, worin $R_2$ n-Butyl, $H_3C$-$(CH_2)_3$-O-$CH_2$- oder einen Rest der Formeln

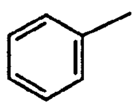 , 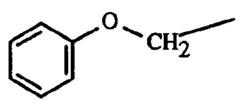 oder 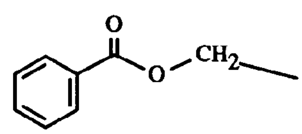

bedeutet.

**7.** Photoempfindliche Zusammensetzungen gemäss Anspruch 1, worin in den Formeln I, II und III $R_4$ einen Rest der Formeln

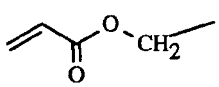 , 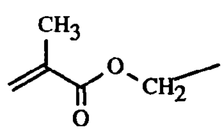 oder 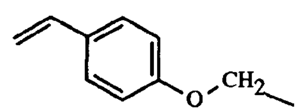

darstellt.

**8.** Photoempfindliche Zusammensetzungen gemäss Anspruch 1, worin in den Formeln II und III A ein Rest $H_3C$-$(CH_2)_y$-CO-O-, $H_3C$-$(CH_2)_y$-O-, -O-CO-$(CH_2)_y$)-CO-O, -O-$(CH_2)_y$-O- oder

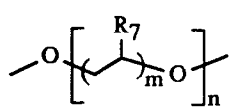

bedeutet, wobei $R_7$ Methyl oder Wasserstoff bei m = 1 oder bei m = 2-4 Wasserstoff ist, n = 2-150 ist und y eine Zahl von 2-20 ist, oder worin A einen Rest basierend auf linearen oder verzweigten Polyethylenglykolen oder Polypropylenglykolen oder Copolymeren aus diesen beiden Glykolen oder carboxylterminierten Polyestern darstellt.

**9.** Photoempfindliche Zusammensetzungen gemäss Anspruch 8, worin A ein Rest $-O-CO-(CH_2)_y-CO-O-$ oder $-O-(CH_2)_y-O-$ bedeutet, wobei y die in Anspruch 8 angegebene Bedeutung hat, oder worin A einen Rest basierend auf linearen oder verzweigten Polyethylenglykolen oder Polypropylenglykolen oder Copolymeren aus diesen beiden Glykolen oder carboxylterminierten Polyestern darstellt.

**10.** Photoempfindliche Zusammensetzungen gemäss Anspruch 1, enthaltend als Komponente c) eine Mono-N-vinylverbindung.

**11.** Photoempfindliche Zusammensetzungen gemäss Anspruch 10, enthaltend als Komponente c) N-Vinylpyrrolidon.

**12.** Photoempfindliche Zusammensetzungen gemäss Anspruch 1, enthaltend als Komponente d) ein 1-Hydroxyphenylketon.

**13.** Photoempfindliche Zusammensetzungen gemäss Anspruch 1, enthaltend als Komponente d) 1 -Hydroxycyclohexylphenylketon.

**14.** Verfahren zum Polymerisieren der Zusammensetzungen gemäss Anspruch 1, indem man diese mit aktinischem Licht bestrahlt.

**15.** Verfahren zur Herstellung von dreidimensionalen Gegenständen aus einer Zusammensetzung gemäss Anspruch 1 mittels lithographischen Verfahren, wobei die Oberfläche einer Schicht der besagten Zusammensetzung ganzflächig oder in einem vorbestimmten Muster mit einer UV/VIS-Lichtquelle bestrahlt wird, so dass sich in den bestrahlten Bereichen eine Schicht in einer gewünschten Schichtdicke verfestigt, dann eine neue Schicht dieser Zusammensetzung auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

**16.** Verfahren gemäss Anspruch 15, indem als Lichtquelle ein Laserstrahl, vorzugsweise ein computergesteuerter Laserstrahl, verwendet wird.

**17.** Verwendung einer Zusammensetzung gemäss Anspruch 1 zur Herstellung von photopolymerisierten Schichten, insbesondere in Form von dreidimensionalen Gegenständen, die aus mehreren aneinander haftenden, verfestigten Schichten aufgebaut sind.

## Claims

### Claims for the following Contracting States : AT, BE, CH, DE, FR, GB, IT, LI, NL, SE

**1.** A photosensitive composition comprising
a) at least 5 % by weight of a polyester of formula I, II or III

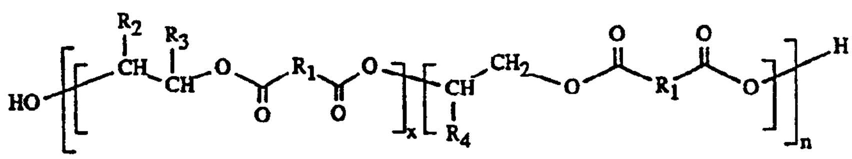

, (I)

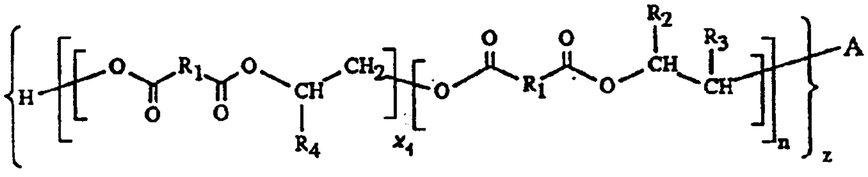

, (II)

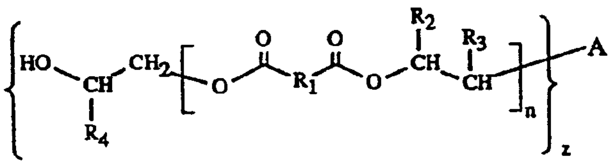 , (III)

wherein
$R_1$ is the radical of a cyclic anhydride of a dicarboxylic acid after removal of the -CO-O-CO- grouping, which radical may be substituted by $C_1$-$C_{22}$alkyl, $C_5$-$C_{10}$cycloalkyl, $C_3$-$C_6$alkenyl, $C_6$-$C_{10}$aryl halogen or $C_1$-$C_{22}$alkyl which is interrupted by -O- or -CO-O-,
$R_2$ is hydrogen, unsubstituted or halogen-substituted $C_1$-$C_{22}$alkyl, $C_5$-$C_{10}$cycloalkyl, $C_7$-$C_{12}$aralkyl, $C_6$-$C_{10}$aryl or a radical $-CH_2-O-R_5$ or $-CH_2-O-CO-R_5$, where $R_5$ is $C_1$-$C_{22}$alkyl, $C_5$-$C_6$cycloalkyl or $C_6$-$C_{10}$aryl,
$R_3$ is hydrogen, or
$R_2$ and $R_3$, together with the carbon atoms to which they are attached, are a cyclopentylene or cyclohexylene radical,
$R_4$ is a radical of 4 to 12 carbon atoms which contains an unsaturated end group and carboxyl or ether groups,
A is a mono- to polyfunctional low-molecular or high-molecular carboxylate or alcoholate,
x is a number from 0-100,
$x_1$ is a number from 1-100,
n is a number from 2-150, and
z is a number from 1-4,
b) 10-90 % by weight of a liquid aliphatic, cycloaliphatic or aromatic di(meth)acrylate and of a liquid aliphatic, cycloaliphatic or aromatic tri(meth)acrylate,
c) 0-70 % of a mono(meth)acrylate or mono-N-vinyl compound with a molecular weight of not more than 500,
d) 0.1-10 % by weight of a photoinitiator, and if desired
e) 0-10 % by weight of customary additives, the overall sum of all components employed always being 100 %.

**2.** A photosensitive composition according to claim 1, comprising
a) at least 30 % by weight of polyester of formula I, II or III,
b) at least 20 % by weight of a liquid aliphatic, cycloaliphatic or aromatic di(meth)acrylate and of a liquid aliphatic, cycloaliphatic or aromatic tri(meth)acrylate,
c) 0-50 % by weight of a mono(meth)acrylate or mono-N-vinyl compound with a molecular weight of not more than 500,
d) 0.5-7 % by weight of a photoinitiator, and if desired
e) 0-5 % by weight of customary additives.

**3.** A photosensitive composition according to claim 1, wherein $R_1$ in formulae I, II and III is a radical of formula

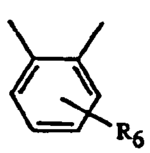 , 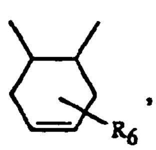 , 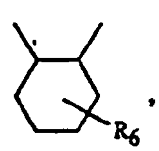 , 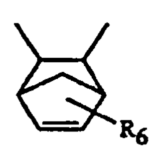 ,

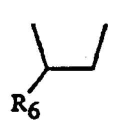 , 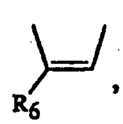 , 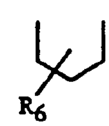 or 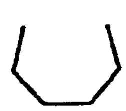 ,

where $R_5$ is hydrogen, $C_1$-$C_{22}$alkyl, $C_5$-$C_{10}$cycloalkyl, $C_3$-$C_6$alkenyl, $C_6$-$C_{10}$aryl, halogen or $C_1$-$C_{22}$alkyl which is interrupted by -O- or -CO-O-.

4. A photosensitive composition according to claim 3, wherein $R_1$ is a radical of formula

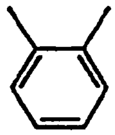 , 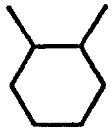 or 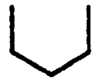 .

5. A photosensitive composition according to claim 1, wherein $R_2$ in formulae I, II and III is hydrogen, methyl, n-butyl, $H_3C-(CH_2)_3-O-CH_2-$ or a radical of formula

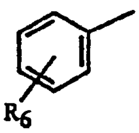 , 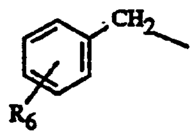 , 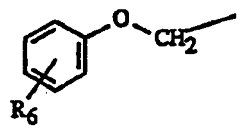

or

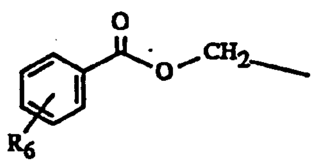

or wherein $R_2$ and $R_3$ together form an unsubstituted or $R_6$-substituted tetramethylene radical, where $R_6$ is as defined in claim 3.

6. A photosensitive composition according to claim 5, wherein $R_2$ is n-butyl, $H_3C-(CH_2)_3-O-CH_2-$ or a radical of formula

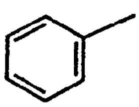 , 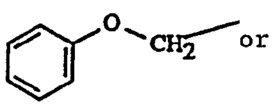 or 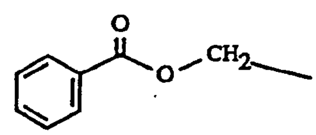 .

7. A photosensitive composition according to claim 1, wherein $R_4$ in formulae I, II and III is a radical of formula

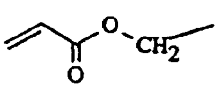 , 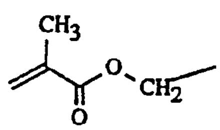 or 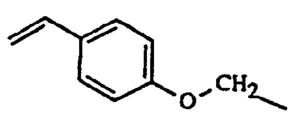 .

8. A photosensitive composition according to claim 1, wherein A in formulae II and III is a radical $H_3C-(CH_2)_y-CO-O-$, $H_3C-(CH_2)_y-O-$, $-O-CO-(CH_2)_y-CO-O-$, $-O-(CH_2)_y-O-$ or

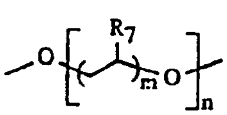 ,

where $R_7$ is methyl or hydrogen if m = 1 or, if m = 2-4, is hydrogen, n = 2-150 and y is an integer from 2-20, or wherein A is a radical based on a linear or branched polyethylene glycol or polypropylene glycol or a copolymer of these two glycols or a carboxyl-terminated polyester.

9. A photosensitive composition according to claim 8, wherein A is a radical $-O-CO-(CH_2)_y-CO-O-$ or $-O-(CH_2)_y-O-$ , where y is as defined in claim 8, or wherein A is a radical based on a linear or branched polyethylene glycol or polypropylene glycol or a copolymer of these two glycols or a carboxyl-terminated polyester.

10. A polyester of formula II or III according to claim 1, wherein the radicals $R_1$, $R_2$, $R_3$, $R_4$, $R_5$ and A, as well as x, $x_1$, n and z are as defined in claim 1.

11. A photosensitive composition according to claim 1, comprising as component c) a mono-N-vinyl compound.

12. A photosensitive composition according to claim 11, comprising as component c) N-vinylpyrrolidone.

13. A photosensitive composition according to claim 1, comprising as component d) a 1-hydroxyphenyl ketone.

14. A photosensitive composition according to claim 1, comprising as component d) 1-hydroxycyclohexyl phenyl ketone.

15. A process for polymerising a composition according to claim 1, by irradiating it with actinic light.

16. A process for the production of a three-dimensional object from a composition according to claim 1 by a lithographic method, wherein the surface of a layer of said composition is irradiated over its entire area or in a predetermined pattern with a UV/VIS light source, such that within the irradiated areas a layer solidifies in a desired layer thickness, then a new layer of this composition is formed on the solidified layer, which is likewise irradiated over its entire area or in a predetermined pattern, and such that a three-dimensional object is obtained by repeated coating and irradiation from a plurality of solidified layers which adhere to one another.

17. A process according to claim 16, wherein a laser beam, preferably a computer-controlled laser beam, is used as light source.

18. Use of a composition according to claim 1 for the production of photopolymerised layers, especially in the form of a three-dimensional object which is formed from a plurality of solidified layers which adhere to one another.

**Claims for the following Contracting State : ES**

1. A photosensitive composition comprising
   a) at least 5 % by weight of a polyester of formula I, II or III

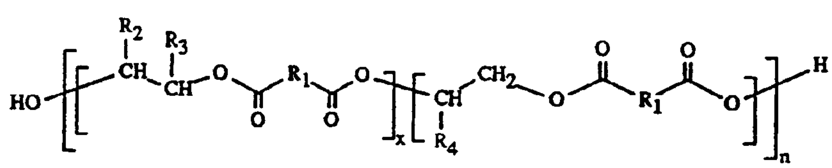

, (I)

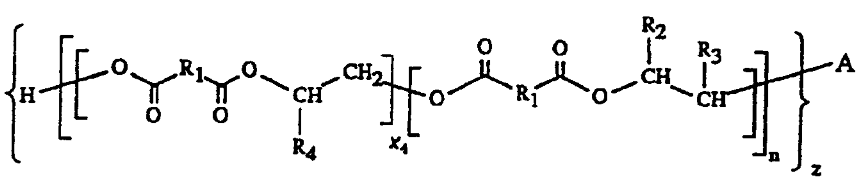

, (II)

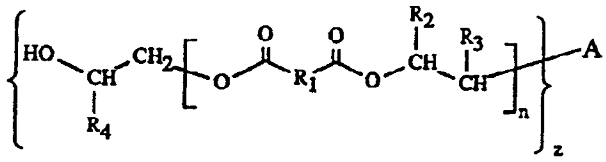 , (III)

wherein
$R_1$ is the radical of a cyclic anhydride of a dicarboxylic acid after removal of the -CO-O-CO- grouping, which radical may be substituted by $C_1$-$C_{22}$alkyl, $C_5$-$C_{10}$cycloalkyl, $C_3$-$C_6$alkenyl, $C_6$-$C_{10}$aryl, halogen or $C_1$-$C_{22}$alkyl which is interrupted by -O- or -CO-O-,
$R_2$ is hydrogen, unsubstituted or halogen-substituted $C_1$-$C_{22}$alkyl, $C_5$-$C_{10}$cycloalkyl, $C_7$-$C_{12}$aralkyl, $C_6$-$C_{10}$aryl or a radical $-CH_2-O-R_5$ or $-CH_2-O-CO-R_5$, where $R_5$ is $C_1$-$C_{22}$alkyl, $C_5$-$C_6$cycloalkyl or $C_6$-$C_{10}$aryl,
$R_3$ is hydrogen, or
$R_2$ and $R_3$, together with the carbon atoms to which they are attached, are a cyclopentylene or cyclohexylene radical,
$R_4$ is a radical of 4 to 12 carbon atoms which contains an unsaturated end group and carboxyl or ether groups,
A is a mono- to polyfunctional low-molecular or high-molecular carboxylate or alcoholate,
x is a number from 0-100,
$x_1$ is a number from 1-100,
n is a number from 2-150, and
z is a number from 1-4,
b) 10-90 % by weight of a liquid aliphatic, cycloaliphatic or aromatic di(meth)acrylate and of a liquid aliphatic, cycloaliphatic or aromatic tri(meth)acrylate,
c) 0-70 % of a mono(meth)acrylate or mono-N-vinyl compound with a molecular weight of not more than 500,
d) 0.1-10 % by weight of a photoinitiator, and if desired
e) 0-10 % by weight of customary additives, the overall sum of all components employed always being 100 %.

2. A photosensitive composition according to claim 1, comprising
a) at least 30 % by weight of polyester of formula I, II or III,
b) at least 20 % by weight of a liquid aliphatic, cycloaliphatic or aromatic di(meth)acrylate and of a liquid aliphatic, cycloaliphatic or aromatic tri(meth)acrylate,
c) 0-50 % by weight of a mono(meth)acrylate or mono-N-vinyl compound with a molecular weight of not more than 500,
d) 0.5-7 % by weight of a photoinitiator, and if desired
e) 0-5 % by weight of customary additives.

3. A photosensitive composition according to claim 1, wherein $R_1$ in formulae I, II and III is a radical of formula

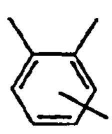 , 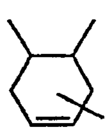 , 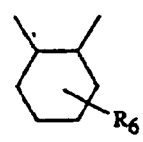 , 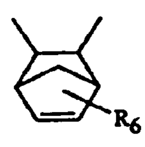 ,

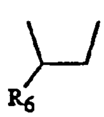 , 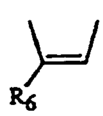 , 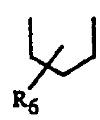 or 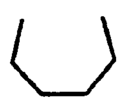 ,

where $R_5$ is hydrogen, $C_1$-$C_{22}$alkyl, $C_5$-$C_{10}$cycloalkyl, $C_3$-$C_6$alkenyl, $C_6$-$C_{10}$aryl, halogen or $C_1$-$C_{22}$alkyl which is interrupted by -O- or -CO-O-.

4. A photosensitive composition according to claim 3, wherein $R_1$ is a radical of formula

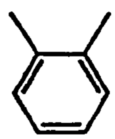, 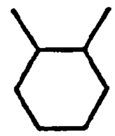 or 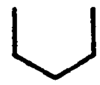

5. A photosensitive composition according to claim 1, wherein $R_2$ in formulae I, II and III is hydrogen, methyl, n-butyl, $H_3C-(CH_2)_3-O-CH_2-$ or a radical of formula

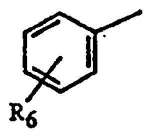, 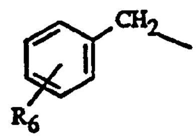, 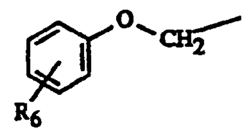

or

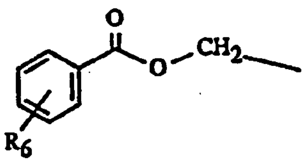.

or wherein $R_2$ and $R_3$ together form an unsubstituted or $R_6$-substituted tetramethylene radical, where $R_6$ is as defined in claim 3.

6. A photosensitive composition according to claim 5, wherein $R_2$ is n-butyl, $H_3C-(CH_2)_3-O-CH_2-$ or a radical of formula

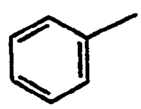, 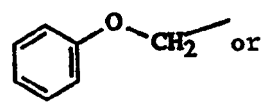 or 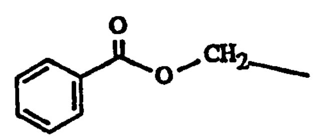.

7. A photosensitive composition according to claim 1, wherein $R_4$ in formulae I, II and III is a radical of formula

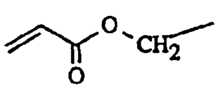, 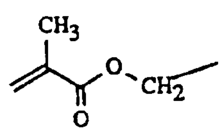 or 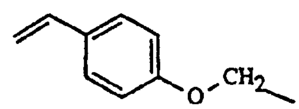.

8. A photosensitive composition according to claim 1, wherein A in formulae II and III is a radical $H_3C-(CH_2)_y-CO-O-$, $H_3C-(CH_2)_y-O-$, $-O-CO-(CH_2)_y-CO-O-$, $-O-(CH_2)_y-O-$ or

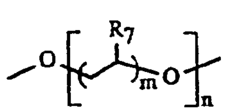,

where $R_7$ is methyl or hydrogen if m = 1 or, if m = 2-4, is hydrogen, n = 2-150 and y is an integer from 2-20, or wherein A is a radical based on a linear or branched polyethylene glycol or polypropylene glycol or a copolymer of these two glycols or a carboxyl-terminated polyester.

9. A photosensitive composition according to claim 8, wherein A is a radical $-O-CO-(CH_2)_y-CO-O-$ or $-O-(CH_2)_y-O-$, where y is as defined in claim 8, or wherein A is a radical based on a linear or branched polyethylene glycol or polypropylene glycol or a copolymer of these two glycols or a carboxyl-terminated polyester.

10. A photosensitive composition according to claim 1, comprising as component c) a mono-N-vinyl compound.

11. A photosensitive composition according to claim 10, comprising as component c) N-vinylpyrrolidone.

12. A photosensitive composition according to claim 1, comprising as component d) a 1-hydroxyphenyl ketone.

13. A photosensitive composition according to claim 1, comprising as component d) 1-hydroxycyclohexyl phenyl ketone.

14. A process for polymerising a composition according to claim 1, by irradiating it with actinic light.

15. A process for the production of a three-dimensional object from a composition according to claim 1 by a lithographic method, wherein the surface of a layer of said composition is irradiated over its entire area or in a predetermined pattern with a UV/VIS light source, such that within the irradiated areas a layer solidifies in a desired layer thickness, then a new layer of this composition is formed on the solidified layer, which is likewise irradiated over its entire area or in a predetermined pattern, and such that a three-dimensional object is obtained by repeated coating and irradiation from a plurality of solidified layers which adhere to one another.

16. A process according to claim 15, wherein a laser beam, preferably a computer-controlled laser beam, is used as light source.

17. Use of a composition according to claim 1 for the production of photopolymerised layers, especially in the form of a three-dimensional object which is formed from a plurality of solidified layers which adhere to one another.

## Revendications

### Revendications pour les Etats contractants suivants : AT, BE, CH, DE, FR, GB, IT, LI, NL, SE

1. Compositions photosensibles contenant :
   a) au moins 5 % en poids d'un polyester de formules I, II ou III

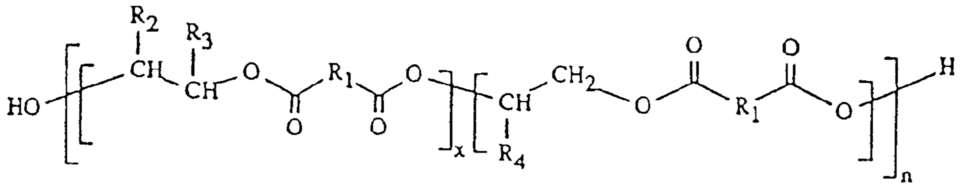 , (I)

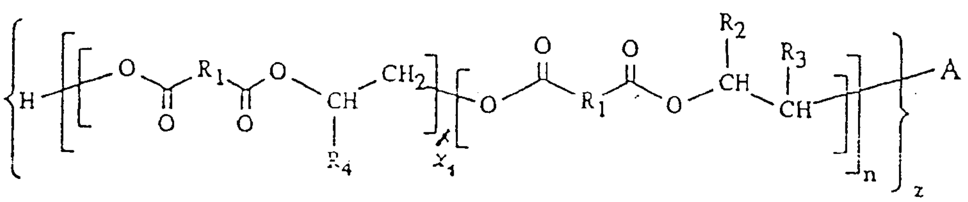 , (II)

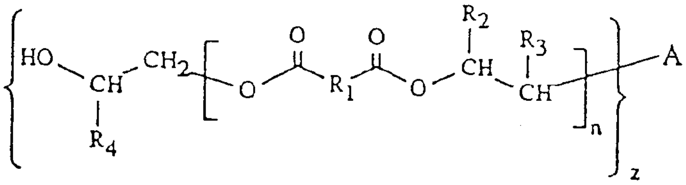,     (III)

dans lesquelles

$R_1$ représente le reste d'un anhydride cyclique d'un acide dicarboxylique après l'élimination du groupement -CO-O-CO-, qui peut être substitué par des alkyle en $C_1$-$C_{22}$, cycloalkyle en $C_5$-$C_{10}$, alcényle en $C_3$-$C_6$, aryle en $C_6$-$C_{10}$, halogène ou alkyle en $C_1$-$C_{22}$, qui est interrompu par -O- ou -CO-O-,

$R_2$ signifie un hydrogène, un reste $-CH_2-O-R_5$ ou $-CH_2-O-CO-R_5$, $R_5$ signifiant un alkyle en $C_1$-$C_{22}$, un cycloalkyle en $C_5$-$C_6$ ou un aryle en $C_6$-$C_{10}$, ou $R_2$ signifie un aryle en $C_6$-$C_{10}$, un aralkyle en $C_7$-$C_{12}$, un cycloalkyle en $C_5$-$C_{10}$ ou un alkyle en $C_1$-$C_{22}$ non substitué ou substitué par des halogènes,

$R_3$ et un hydrogène ou bien

$R_2$ et $R_3$ représentent ensemble avec l'atome de carbone auquel ils sont liés un reste cyclopentylène ou cyclohexylène,

$R_4$ représente un reste ayant de 4 à 12 atomes de carbone, qui contient un groupe terminal insaturé et des groupes carboxyl ou éther,

A représente un alcoolate ou un carboxylate, mono ou polyfonctionnel, à bas ou haut poids moléculaire,

x est un nombre allant de 0 à 100,

$x_1$ est un nombre allant de 1 à 100,

n est un nombre allant de 2 à 150,

z est un nombre allant de 1 à 4,

b) de 10 à 90 % en poids d'un di(méth-)acrylate liquide, aliphatique, cycloaliphatique ou aromatique et un tri(méth-)acrylate liquide, aliphatique, cycloaliphatique ou aromatique,

c) de 0 à 70 % en poids d'un mono-(méth-)acrylate ou d'un composé mono-N-vinylique ayant un poids moléculaire au maximum de 500,

d) de 0,1 à 10 % en poids d'un photoinitiateur et éventuellement

e) de 0 à 10 % en poids d'additifs classiques, la somme totale de tous les composants individuels valant toujours 100 % en poids.

**2.** Compositions photosensibles selon la revendication 1 contenant

a) au moins 30 % en poids d'un polyester de formules I, II ou III,

b) au moins 20 % en poids d'un di(méth-)acrylate liquide, aliphatique, cycloaliphatique ou aromatique et un tri(méth-)acrylate liquide, aliphatique, cycloaliphatique ou aromatique,

c) de 0 à 50 % en poids d'un mono-(méth-)acrylate ou d'un composé mono-N-vinylique ayant un poids moléculaire au maximum de 500,

d) de 0,5 à 7 % en poids d'un photoinitiateur et éventuellement

e) de 0 à 5 % en poids d'additifs classiques.

**3.** Compositions photosensibles selon la revendication 1 dans laquelle dans les formules I, II et III, $R_1$ représente un reste de formule

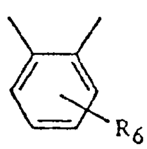 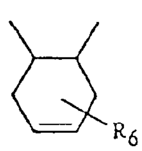 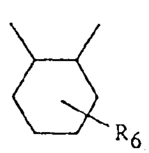 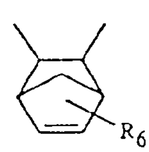

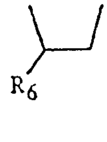 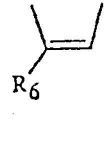 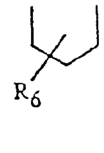 ou 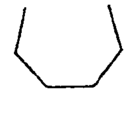

$R_6$ signifiant un hydrogène, un alkyle en $C_1$-$C_{22}$, un cycloalkyle en $C_5$-$C_{10}$, un alcényle en $C_3$-$C_6$, un aryle

en $C_6$-$C_{10}$, un halogène ou un alkyle en $C_1$-$C_{22}$, qui est interrompu par -O- ou -CO-O-.

4. Compositions photosensibles selon la revendication 3 dans laquelle $R_1$ représente un reste de formule

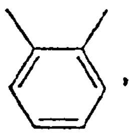 , 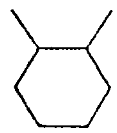 ou 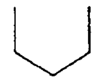

5. Compositions photosensibles selon la revendication 1, dans laquelle dans les formules I, II et III, $R_2$ signifie un hydrogène, un méthyle, un n-butyle, un H3C-$(CH_2)_3$-O-$CH_2$- ou un reste de formule

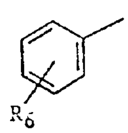 , 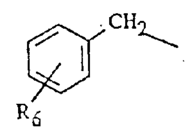 , 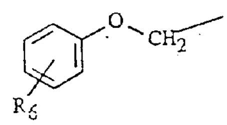 ou 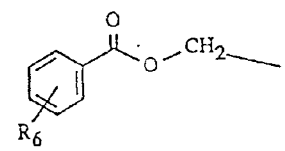

ou bien dans laquelle $R_2$ et $R_3$ forment ensemble un reste tétraméthylène non substitué ou bien substitué par $R_6$, $R_6$ ayant la signification indiquée dans la revendication 3.

6. Compositions photosensibles selon la revendication 5, dans laquelle $R_2$ signifie un n-butyle, un $H_3C$-$(CH_2)_3$-O-$CH_2$- ou un reste de formule

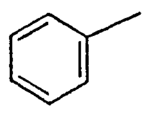 , 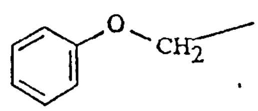 . ou 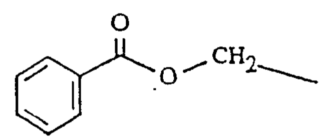

7. Compositions photosensibles selon la revendication 1, dans laquelle dans les formules I, II et III, $R_4$ représente un reste de formule

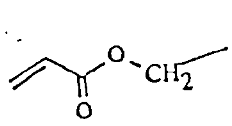 , 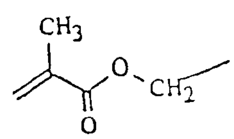 ou 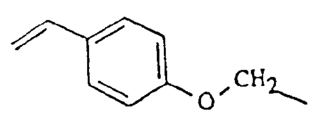

8. Compositions photosensibles selon la revendication 1, dans laquelle dans les formules II et III, A signifie un reste $H_3C$-$(CH_2)_y$-CO-O-, $H_3C$-$(CH_2)_y$-O-, -O-CO-$(CH_2)_y$-CO-O-, -O-$(CH_2)_y$,-O- ou

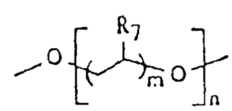 ,

$R_7$ étant un méthyle ou un hydrogène lorsque m vaut 1 et un hydrogène lorsque m vaut de 2 à 4, n valant entre 2 et 150 et y étant un nombre allant de 2 à 20, ou dans laquelle A représente un reste à base de polyéthylèneglycol ou de polypropylèneglycol linéaire ou ramifié ou de copolymères de ces deux glycols ou bien des polyesters à terminaisons carboxyles.

9. Compositions photosensibles selon la revendication 8, dans laquelle A signifie un reste -O-CO-$(CH_2)_y$-CO-O- ou -O-$(CH_2)_y$-O-, y ayant la signification donnée dans la revendication 8, ou dans laquelle A représente un reste à base de polyéthylèneglycol ou de polypropylèneglycol linéaire ou ramifiée ou bien

de copolymères de ces deux glycols ou bien de polyesters à terminaisons carboxyles.

10. Polyester de formules II et III selon la revendication 1, les restes $R_1$, $R_2$, $R_3$, $R_4$, $R_5$ et A, ainsi que x, $x_1$, n et z ayant la signification indiquée dans la revendication 1.

11. Compositions photosensibles selon la revendication 1, contenant en tant que composant c), un composé mono-N-vinylique.

12. Compositions photosensibles selon la revendication 11, contenant en tant que composant c), un N-vinylpyrrolidone.

13. Compositions photosensibles selon la revendication 1, contenant en tant que composant d), une 1-hydroxyphénylcétone.

14. Compositions photosensibles selon la revendication 1, contenant en tant que composant d), la 1-hydroxycyclohexylphénylcétone.

15. Procédé de polymérisation des compositions selon la revendication 1, en irradiant celle-ci avec une lumière actinique.

16. Procédé de préparation d'objets tridimensionnels à partir d'une composition selon la revendication 1 au moyen d'un procédé lithographique, la surface d'une couche à base de ladite composition étant irradiée sur toute la surface ou selon un modèle prédéterminé avec une source de lumière UV/Vis, de sorte que une couche soit durcie avec une épaisseur de couche désirée dans le domaine irradié, ensuite en formant une nouvelle couche à base de ladite composition sur la couche durcie, que l'on irradie de même sur toute la surface ou bien selon un modèle prédéterminé, et en obtenant des objets tridimensionnels à base de plusieurs couches durcies adhérentes l'une à l'autre.

17. Procédé selon la revendication 16, en utilisant en tant que source de lumière un rayon laser, de préférence un rayon laser assisté par ordinateur.

18. Utilisation d'une composition selon la revendication 1 en vue de la préparation de couches photopolymérisées, en particulier sous la forme d'objets tridimensionnels, qui sont construits à partir de plusieurs couches compactes adhérentes l'une à l'autre.

**Revendications pour l'Etat contractant suivant : ES**

1. Compositions photosensibles contenant :
   a) au moins 5 % en poids d'un polyester de formules I, II ou III

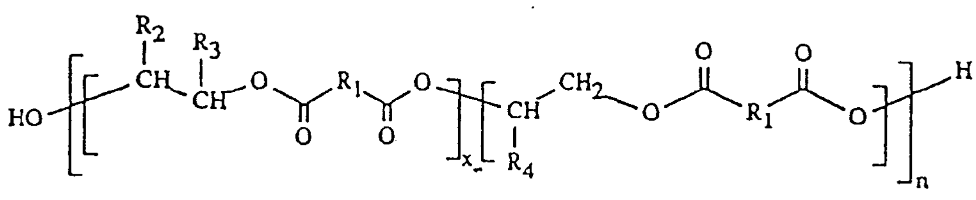

, (I)

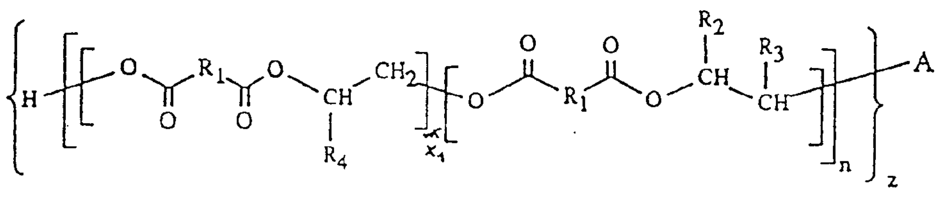

, (II)

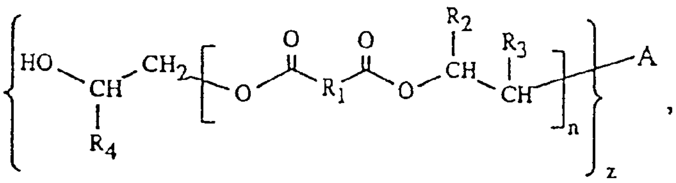 , (III)

dans lesquelles
$R_1$ représente le reste d'un anhydride cyclique d'un acide dicarboxylique après l'élimination du groupement -CO-O-CO-, qui peut être substitué par des alkyle en $C_1$-$C_{22}$, cycloalkyle en $C_5$-$C_{10}$, alcényle en $C_3$-$C_6$, aryle en $C_6$-$C_{10}$, halogène ou alkyle en $C_1$-$C_{22}$, qui est interrompu par -O- ou -CO-O-,
$R_2$ signifie un hydrogène, un reste $-CH_2-O-R_5$ ou $-CH_2-O-CO-R_5$, $R_5$ signifiant un alkyle en $C_1$-$C_{22}$, un cycloalkyle en $C_5$-$C_6$ ou un aryle en $C_6$-$C_{10}$, ou $R_2$ signifie un aryle en $C_6$-$C_{10}$, un aralkyle en $C_7$-$C_{12}$, un cycloalkyle en $C_5$-$C_{10}$ ou un alkyle en $C_1$-$C_{22}$ non substitué ou substitué par des halogènes,
$R_3$ et un hydrogène ou bien
$R_2$ et $R_3$ représentent ensemble avec l'atome de carbone auquel ils sont liés un reste cyclopentylène ou cyclohexylène,
$R_4$ représente un reste ayant de 4 à 12 atomes de carbone, qui contient un groupe terminal insaturé et des groupes carboxyl ou éther,
A représente un alcoolate ou un carboxylate, mono ou polyfonctionnel, à bas ou haut poids moléculaire,
x est un nombre allant de 0 à 100,
$x_1$ est un nombre allant de 1 à 100,
n est un nombre allant de 2 à 150,
z est un nombre allant de 1 à 4,
b) de 10 à 90 % en poids d'un di(méth-)acrylate liquide, aliphatique, cycloaliphatique ou aromatique et un tri(méth-)acrylate liquide, aliphatique, cycloaliphatique ou aromatique,
c) de 0 à 70 % en poids d'un mono-(méth-)acrylate ou d'un composé mono-N-vinylique ayant un poids moléculaire au maximum de 500,
d) de 0,1 à 10 % en poids d'un photoinitiateur et éventuellement
e) de 0 à 10 % en poids d'additifs classiques, la somme totale de tous les composants individuels valant toujours 100 % en poids.

2. Compositions photosensibles selon la revendication 1 contenant
a) au moins 30 % en poids d'un polyester de formules I, II ou III,
b) au moins 20 % en poids d'un di(méth-)acrylate liquide, aliphatique, cycloaliphatique ou aromatique et un tri(méth-)acrylate liquide, aliphatique, cycloaliphatique ou aromatique,
c) de 0 à 50 % en poids d'un mono-(méth-)acrylate ou d'un composé mono-N-vinylique ayant un poids moléculaire au maximum de 500,
d) de 0,5 à 7 % en poids d'un photoinitiateur et éventuellement
e) de 0 à 5 % en poids d'additifs classiques.

3. Compositions photosensibles selon la revendication 1 dans laquelle dans les formules I, II et III, $R_1$ représente un reste de formule

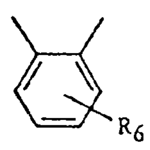 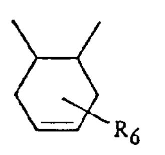 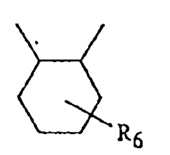 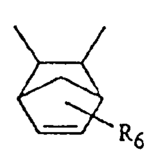

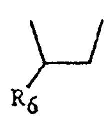 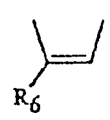 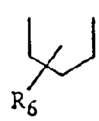 ou 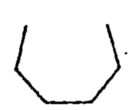

$R_6$ signifiant un hydrogène, un alkyle en $C_1$-$C_{22}$, un cycloalkyle en $C_5$-$C_{10}$, un alcényle en $C_3$-$C_6$, un aryle en $C_6$-$C_{10}$, un halogène ou un alkyle en $C_1$-$C_{22}$, qui est interrompu par -O- ou -CO-O-.

4. Compositions photosensibles selon la revendication 3 dans laquelle $R_1$ représente un reste de formule

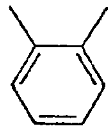 , 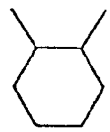 ou 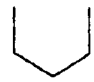

5. Compositions photosensibles selon la revendication 1, dans laquelle dans les formules I, II et III, $R_2$ signifie un hydrogène, un méthyle, un n-butyle, un $H_3C-(CH_2)_3-O-CH_2-$ ou un reste de formule

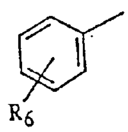 , 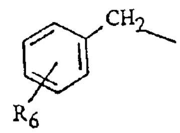 , 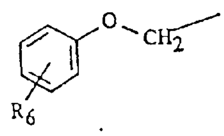 ou 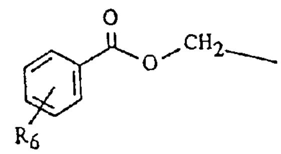

ou bien dans laquelle $R_2$ et $R_3$ forment ensemble un reste tétraméthylène non substitué ou bien substitué par $R_6$, $R_6$ ayant la signification indiquée dans la revendication 3.

6. Compositions photosensibles selon la revendication 5, dans laquelle $R_2$ signifie un n-butyle, un $H_3C-(CH_2)_3-O-CH_2-$ ou un reste de formule

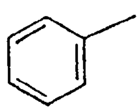 , 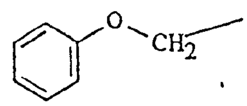 ou 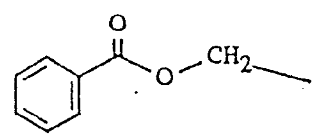

7. Compositions photosensibles selon la revendication 1, dans laquelle dans les formules I, II et III, $R_4$ représente un reste de formule

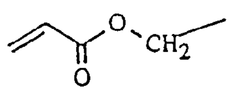 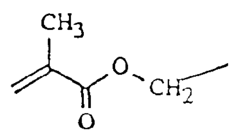 ou 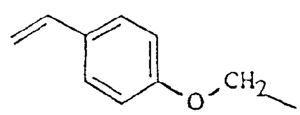

8. Compositions photosensibles selon la revendication 1, dans laquelle dans les formules II et III, A signifie un reste $H_3C-(CH_2)_y-CO-O-$, $H_3C-(CH_2)_y-O-$, $O-CO-(CH_2)_y-CO-O-$, $-O-(CH_2)_y-O-$ ou

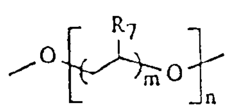 ,

$R_7$ étant un méthyle ou un hydrogène lorsque m vaut 1 et un hydrogène lorsque m vaut de 2 à 4, n valant entre 2 et 150 et y étant un nombre allant de 2 à 20, ou dans laquelle A représente un reste à base de polyéthylèneglycol ou de polypropylèneglycol linéaire ou ramifié ou de copolymères de ces deux glycols ou bien des polyesters à terminaisons carboxyles.

9. Compositions photosensibles selon la revendication 8, dans laquelle A signifie un reste $-O-CO-(CH_2)_y-CO-O-$ ou $-O-(CH_2)_y-O-$, y ayant la signification donnée dans la revendication 8, ou dans laquelle A représente un reste à base de polyéthylèneglycol ou de polypropylèneglycol linéaire ou ramifiée ou bien de copolymères de ces deux glycols ou bien de polyesters à terminaisons carboxyles.

10. Compositions photosensibles selon la revendication 1, contenant en tant que composant c), un composé mono-N-vinylique.

11. Compositions photosensibles selon la revendication 10, contenant en tant que composant c), un N-vinylpyrrolidone.

12. Compositions photosensibles selon la revendication 1, contenant en tant que composant d), une 1-hydroxyphénylcétone.

13. Compositions photosensibles selon la revendication 1, contenant en tant que composant d), la 1-hydroxycyclohexylphénylcétone.

14. Procédé de polymérisation des compositions selon la revendication 1, en irradiant celle-ci avec une lumière actinique.

15. Procédé de préparation d'objets tridimensionnels à partir d'une composition selon la revendication 1 au moyen d'un procédé lithographique, la surface d'une couche à base de ladite composition étant irradiée sur toute la surface ou selon un modèle prédéterminé avec une source de lumière UV/Vis, de sorte que une couche soit durcie avec une épaisseur de couche désirée dans le domaine irradié, ensuite en formant une nouvelle couche à base de ladite composition sur la couche durcie, que l'on irradie de même sur toute la surface ou bien selon un modèle prédéterminé, et en obtenant des objets tridimensionnels à base de plusieurs couches durcies adhérentes l'une à l'autre.

16. Procédé selon la revendication 15, en utilisant en tant que source de lumière un rayon laser, de préférence un rayon laser assisté par ordinateur.

17. Utilisation d'une composition selon la revendication 1 en vue de la préparation de couches photopolymérisées, en particulier sous la forme d'objets tridimensionnels, qui sont construits à partir de plusieurs couches compactes adhérentes l'une à l'autre.